# EUROPEAN PATENT SPECIFICATION

(11) **EP 0 784 103 B1**
(45) Date of publication and mention of the grant of the patent: **09.04.2003**
(21) Application number: 97100089.8
(22) Date of filing: 04.01.1997
(51) Int. Cl.: C23C 16/40

(54) **Method of manufacturing coated cutting tools**
Verfahren zur Herstellung von beschichteten Schneideinsätzen
Procédé de fabrication de plaquettes de coupe revêtues

(30) Priority: 10.01.1996 JP 229296; 25.03.1996 JP 6811496; 12.04.1996 JP 9102596; 15.04.1996 JP 9242396; 16.04.1996 JP 9396696; 15.11.1996 JP 30433596; 15.11.1996 JP 30433696
(43) Date of publication of application: 16.07.1997
(73) Proprietor: MITSUBISHI MATERIALS CORPORATION, Chiyoda-ku, Tokyo 100 (JP)
(72) Inventor: Nakamura, Eiji, Mitsubishi Materials Corporation, Omiya, Saitama 330 (JP); Ueda, Toshiaki, Mitsubishi Materials Corporation, shigemachi, Yuuki-gun, Ibaragi-ken (JP); Yamada, Takashi Mitsubishi Materials Corporation, Ishigemachi, Yuuki-gun, Ibaragi-ken (JP); Oshika, Takatoshi, Mitsubishi Materials Corp., Omiya, Saitama 330 (JP)
(74) Representative: Gille Hrabal Struck Neidlein Prop Roos

(56) References cited:
- WO-A-92/17623
- US-A- 4 112 148
- PLASMA CHEMISTRY AND PLASMA PROCESSING, vol. 12, no. 2, 1 June 1992, pages 129-145, XP000266311 PATSCHEIDER J ET AL: "PLASMA-INDUCED DEPOSITION OF THIN FILMS OF ALUMINUM OXIDE"
- PATENT ABSTRACTS OF JAPAN vol. 009, no. 088 (C-276), 17 April 1985 & JP 59 219465 A (SUMITOMO DENKI KOGYO KK), 10 December 1984,
- PATENT ABSTRACTS OF JAPAN vol. 009, no. 331 (C-321), 25 December 1985 & JP 60 159171 A (SUMITOMO DENKI KOGYO KK), 20 August 1985,
- BERICHTE DER DEUTSCHEN KERAMISCHEN GESELLSCHAFT, MARCH 1972, WEST GERMANY, vol. 49, no. 3, ISSN 0365-9542, pages 76-80, XP000671483 SCHACHNER H ET AL: "Chemical vapour deposition of aluminium oxide layers on aluminium by hydrolysis of aluminium chloride"

## Description

### BACKGROUND OF THE INVENTION

### 1. Field of the Invention

The present invention relates to a method of manufacturing a coated cutting tool arranged such that an aluminum oxide layer constituting a hard coated layer has a uniform layer thickness even if it is formed to a thick film as well as exhibits an excellent adherence property to other layers constituting the cutting tool, thus when the tool is used particularly to intermittent cutting in addition, needless to say, to continuous cutting, it can exhibit excellent cutting performance for a long time without the occurrence of chipping and the like.

### 2. Description of the Related Art

As a hard-material-coated sintered carbide cutting tool, there is conventionally known a coated cutting tool which comprises a cemented carbide substrate of a tungsten carbide group (hereinafter, referred to as a cemented carbide substrate) the surface of which is coated with a hard coated layer including an Al₂O₃ layer such as, for example, a hard coated layer composed of the Al₂O₃ layer and one, two or more of a titanium carbide (hereinafter, shown by TiC) layer, a titanium nitride (hereinafter, shown by TiN) layer, a titanium carbonitride (hereinafter, shown by TiCN) layer, a titanium oxide (hereinafter, shown by TiO₂) layer, a titanium oxycarbide (hereinafter, shown by TiCO) layer, a titanium oxynitride (hereinafter, shown by TiNO) layer, and a titanium oxycarbonitride (hereinafter, shown by TiCNO) layer using chemical vapor deposition and/or physical vapor deposition to an average layer thickness of 3 - 20 µm (microns).

Further, it is also known that the Al₂O₃ layer constituting the hard coated layer of the above coated cemented carbide cutting tool is formed using a reaction gas having the following composition in vol% (hereinafter, vol% is simply shown by %) under the conditions of a reaction temperature: 950 - 1100°C and an Atmospheric pressure: 2.7-27 kPa (20 - 200 torr) in hydrogen ambient.
Aluminum.trichloride (hereinafter, shown by AlCl₃) : 1 - 20%
Carbon dioxide (hereinafter, shown by CO₂) : 1 - 20%
(when necessary, carbon monoxide (CO) or hydrogen chloride (HCl): 1 - 30%)
Hydrogen: remainder

On the other hand, recently, there is a remarkable tendency for executing automatic cutting operation and strongly requesting labor cost saving in factories and accordingly it is required to more prolong the usable life of coated tools. As means for coping with the above requirement, it has been widely examined to increase the thickness of the Al₂O₃ layer which is excellent in oxidation resistance and thermal stability and further has high hardness among the hard coated layers constituting the tool.

Meanwhile, it is a disadvantage of thickening the Al₂O₃ layer, that the toughness of the thicker Al₂O₃ layer becomes less sufficient because of its intrinsic brittleness. To overcome this disadvantage, Japanese Unexamined Patent Publication No. 60-159171 disclosed a layer which comprises an AION solid solution phase or a mixture of Al₂O₃ and AION phases, produced by the vapour deposition process using AlCl₃, NO and/or NO₂ as oxygen and nitrogen sources, and H₂ as a carrier gas. It was also disclosed, that the layer being composed of an AION solid solution phase or a mixture of Al₂O₃ and
AION phases exhibits fairly tough characteristics.
Another problem occurring in a rather thicker Al₂O₃ layer is local unevenness of the thickness of the Al₂O₃ layer among the flank face, the rake face and the cutting edge of the Insert, irrespective of the deposition method, whether a conventional method or the above moderate method of Japanese Unexamined Patent Publication No. 60-159171 is used. The thickness at the cutting edge portion is apt to be thicker than the other portion such as the rake face. This feature induces the rather early occurrence of chipping at the cutting edges.

Further, said inevitably too thick Al₂O₃ layer at the cutting edge is also responsible for rather weak adhesion strength between the Al₂O₃ layer and the underlying layer beneath the Al₂O₃ layer at said portion. Consequently, the cutting edge is liable to be chipped off when the coated cutting tool is used to the intermittent cutting operation of for example steel, cast iron and the like, and the usable life of the tool is finished in a relatively short period of time at present.

### SUMMARY OF THE INVENTION

The inventors paid attention particularly to the formation of an Al₂O₃ layer constituting the hard coated layer from the aforesaid point of view in the manufacture of a coated cutting tool and made study for reducing the local dispersion of a layer thickness and enhancing an adherence property when the Al₂O₃ layer is formed to a thick film. As a result, the inventors obtained the result of the study shown in the following items (A, (B) and (C).
(A) In an Al₂O₃ layer formed using a conventional hydrogen atmosphere, CO₂ and hydrogen (H₂) as components constituting the reaction gas reacts to each other according to the following reaction formula (1). ${\text{CO}}_{\text{2}} {\text{+ H}}_{\text{2}} {\text{→ CO + H}}_{\text{2}} \text{O}$As a result, resultant H₂O reacts to AlCl₃ according to the following reaction formula (2) so that Al₂O₃ is created by the hydrolysis of AlCl₃. ${\text{AlCl}}_{\text{3}} {\text{+ H}}_{\text{2}} {\text{O → Al}}_{\text{2}} {\text{O}}_{\text{3}} \text{+ HCl}$In this case, since the reaction based on the formula (2) is very promptly executed as compared with the reaction based on the formula (1), H₂O created by the formula (1) promptly reacts to AlCl₃ existing in a reaction atmosphere. Therefore, there is employed such a reaction mechanism that almost all of Al₂O₃ was created in the gas phase and consequently the Al₂O₃ layer is formed by the deposition of the Al₂O₃ nuclei onto the surface of substrate. Consequently, it is difficult to form Al₂O₃ layers having a uniform layer thickness to the flank face, the rake face of a cutting portion and the cutting edge where the flank face intersects the rake face even if, for example, a cutting insert is placed in the flow of the reaction gas in any state. This difficulty is also increased by that the Al₂O₃ layers are affected by the flow of the reaction gas and the shape of the substrate, thus the occurrence of great dispersion in the layer thickness cannot be avoided.
(B) Since the examination of the above item (A) has resulted in the conclusion that when a layer is made by creating Al₂O₃ nuclei adjacent to the surface as close as possible, the layer thickness thereof can be made uniform, the inventors have tried to develop a reaction gas which permits the above layer formation. As a result, the inventors have developed an inert gas type reaction gas having the following composition as the reaction gas.
   AlCl₃: 0.5 - 10%
   Nitrogen oxides (hereinafter, shown by NOₓ): 1 - 30%
   Inert gas as the carrier gas: remainder
   When the inert gas type reaction gas mentioned above is used, NOₓ is dissolved at the surface of substrate according to the following reaction formula (a) and O created by the reaction according to the formula (a) is adsorbed to that surface, thus, the above O reacts with AlCl₃ at that surface according to the following reaction formula (b). ${\text{NO}}_{\text{x}} {\text{→ N}}_{\text{2}} \text{+ O}$${\text{AlCl}}_{\text{3}} {\text{+ O → Al}}_{\text{2}} {\text{O}}_{\text{3}} {\text{+ Cl}}_{\text{2}}$Therefore, the layer is formed in the state that the Al₂O₃ nuclei mainly formed at the surface of substrate, less formed in the gas phase, and the diposited layer is not almost affected by the flow of the reaction gas and the shape of the substrate. As a result, the resultant deposited layer has a very small amount of local dispersion even if it is formed to a thick layer and further the adherence property of the layer to the substrate is more enhanced. In addition, since the deposited layer is mainly composed of Al₂O₃, that is, an aluminum oxide layer in which the content of the components constituting the reaction gas except Al and oxygen is 15% or less and preferably 10% or less; the deposited layer has oxidation resistance, thermal stability and high hardness similar to the characteristics provided with Al₂O₃.
(C) TiCl₄, ZrCl₄ and HfCl₄ gases additionally mixed with the reaction gas act as a catalyst causing to the reaction NOₓ → N₂ + O (a).

Note, the inventors define the aluminum oxide layer described here as a crystalline/non-crystalline aluminum oxide compound layer in which the content of the components constituting the reaction gas except Al and O is 15% or less.

The present invention achieved based on the result of the above study relates to a method of manufacturing a coated tool by forming a hard coated layer including an aluminum oxide layer, for example, a hard coated layer composed of the aluminum oxide layer and one, two or more of a TiC layer, a TiN layer, a TiCN layer, a TiO₂ layer, a TiCO layer, a TiNO layer, and a TiCNO layer on the surface of a substrate to an average layer thickness of 3 - 20 microns using chemical vapor deposition and/or physical vapor deposition. The method of manufacturing the coated tool has a feature that when the aluminum oxide layer constituting the hard coated layer is formed as relatively thicker layer using an inert gas type reaction gas having the following composition, the thick layer is evenly formed and an adherence property is enhanced and as a result an excellent chipping resistance property is exhibited.
AlCl₃: 0.5 - 10%
NOₓ: 1 - 30%
TiCl₄: 0 - 1%
N₂: 0 - 15%
H₂: 0 - 20%
(however, the ratio of Al₂O₃ to TiCl₄ is 5 - 100 under the existence of TiCl₄).
Inert gas: remainder
The present invention is characterized in a method of manufacturing the coated cutting tool in which the use of the inert gas type reaction gas having the above composition makes the layer thickness of the thickened layer uniform and enhances the adherence property so as to exhibit excellent chipping resistance.
Reasons of limitation

Next, reasons why the composition of the reaction gas is limited as mentioned above will be described.

### (a) AlCl₃

When the ratio of AlCl₃ is less than 0.5%, since the Al source of Al₂O₃ is insufficient, the formation of an aluminum oxide layer is delayed to a practically unacceptable level, whereas when the ratio exceeds 10%, since the Al source is excessively supplied, the crystalline of the aluminum oxide layer (deposited layer is lowered, thus the ratio is set to 0.5 - 10% and preferably to 2 - 7%.

### (b) NOₓ

When the ratio of NOₓ is less than 1%, since the Al source is excessively supplied with respect to the O source of Al₂O₃, the crystalline of the deposited layer is lowered, whereas when the ratio exceeds 30%, since dissolved O excessively exists to the Al source on the contrary, local unevenness is caused to the reaction by the above formula (b) and the uniformity of a layer thickness is lowered, thus the ratio is preferably set to 1 - 30% and more preferably to 5 - 20%.

### (c) TiCl₄

Although TiCl₄ is a selective component which accelerates the reaction of the formula (a) NOx - N₂ + O, when the ratio of it is less than 0.01%, since the reaction of the above formula (a) is not sufficiently carried out and the supply of the O source of Al₂O₃ is made insufficient, not only a layer cannot be formed at a practical speed but also the uniformity of the thickness of the layer is damaged. Whereas when the ratio exceeds 1%, a large amount of Ti exists in a reaction atmosphere by which the crystalline of a deposited layer is lowered. Thus, the ratio is preferably set to 0.01 - 1% and more preferably to. 0.1 - 0.5%.

### (d) H₂

Although H₂ is a selective component which activates the reaction atmosphere, when the ratio of it less than 0.5%, the reaction atmosphere cannot be activated to a desired level, whereas when the ratio exceeds 20%, the layer thickness of the deposited layer is made uneven. Thus, the ratio is preferably set to 0.5 - 20% and more preferably to 1 - 10%.

### (e) N₂

Although a component N₂ has an action for stabilizing the reaction of the formula (a), that is, an action for suppressing the mutual bonding of created O, when the ratio of it is less than 1%, a desired effect cannot be obtained to the above action, whereas when the ratio exceeds 15%, there is a tendency that a deposited layer forming speed is lowered. Thus, the ratio is set to 1 - 15% and preferably to 4 - 10%.

### (f) Volume ratio of AlCl₃ to TiCl₄ (AlCl₃/TiCl₄)

As to TiCl₄ as a selective component, when the volume ratio of AlCl₃ to it is less than 5, the ratio of a Ti source to the Al source in the reaction atmosphere is excessively increased in the reaction atmosphere by which the crystalline of the deposited layer is lowered and predetermined characteristics cannot be secured to the aluminum oxide layer, whereas when the ratio exceeds 100, since the ratio of Ti in the reaction atmosphere is excessively decreased, a NOₓ dissolving action carried out by Ti on the surface of substrate is greatly lowered particularly at a reaction temperature equal to or less than 1000°C, the O source of Al₂O₃ is insufficiently supplied and the layer forming speed is lowered. Thus, the ratio is set to 5 - 100, preferably to 10 - 100 and more preferably to 10 - 50.

### (g) Others

Note, as to a reaction temperature and an atmospheric pressure as other manufacturing conditions, the reaction temperature is set to 850 - 1150°C and preferably to 900 - 1100°C and the atmospheric pressure is set to 2.7 - 27 kPa (20 - 200 torr) and preferably to 5.3 - 13.3 kPa (40 - 100 torr). This is because that when the reaction temperature is less than 850°C, the crystalline of the deposited layer is lowered, whereas when the temperature exceeds 1150°C, the aluminum oxide layer is coarsened and wear resistance is lowered. The reaction temperature is more preferably set to 900 - 1100°C. In addition, when the atmospheric pressure is less than 2.7 kPa (20 torr), reaction is slowly carried out and the layer is not formed at a predetermined speed, whereas when the pressure exceeds 27 kPa (200 torr), the surface of the aluminum oxide layer is made irregular by which the layer thickness is made uneven.

Further, a reason why the average layer thickness of a hard coated layer is set to 3 - 20 µm is that when the layer thickness is less than 3 µm, a desired excellent wear resistance cannot be secured, whereas when the layer thickness exceeds 20 µm, breakage and chipping is liable to be caused to a cutting edge.

This invention is not limited only to the substrate of cemented carbide but also applicable to other substrates such as Al₂O₃, AlN, Si₃N₄ or SiC base and their combination type ceramics and TiC, TiN, TiCN type cermet and the like which are stable under the condition of the method of the invention.

The inventors also use coated cutting tools which are not limited only to cutting insert but include reamer, end mill and the like required for longer tool life.

### DESCRIPTION OF THE PREFERRED EMBODIMENTS

### (1) Embodiment 1

There were prepared, as powder materials, medium grain WC powder having an average grain size of 2.8 microns, rough grain WC powder having an average grain size of 4.9 µm, (Ti, W) C (TiC/WC = 30/70 in a wt%, shown likewise hereinafter) powder having an average grain size of 1.5 µm, (Ti, W) CN (TiC/TiN/WC = 24/20/56) powder having an average grain size of 1.2 µm, (Ta, Nb) C (TaC/NbC = 90/10) powder having an average grain size of 1.2 µm, and Co powder having an average grain size of 1.1 µm, respectively. These powder materials were blended to have the blended compositions shown in Table 1 and wet mixed in a ball mill for 72 hours and dried. Then, they were molded to green compacts having the shapes regulated by ISO/CNMG120408 (for cemented carbide substrates A - D) and ISO/SEEN42AFTN1 (for cemented carbide substrate E) by a press and the resultant green compacts were made to the cemented carbide substrates A - E by being subjected to vacuum sintering under the conditions also shown in Table 1, respectively.

The cemented carbide substrate B was held in the atmosphere of a CH₄ gas of 13.3 kPa (100 torr) at 1,400°C for one hour and then subjected to carburization while being gradually cooled. After the processing, a Co-enriched-zone having a maximum Co content of 15.9 wt% and a depth of 42 µm was formed to the surface of the substrate by removing carbon and Co attached to the surface of the cemented carbide substrate by acid and barrel grinding.

Further, each of the cemented carbide substrates A and D had a Co-enriched-zone having a maximum Co content of 9.1 wt% and a depth of 23 µm, whereas the remaining cemented carbide substrates C and E had no Co-enriched-zone formed thereto and had a uniform structure as a whole. Note, Table 1 shows the internal hardness of the above respective cemented carbide substrates A - E. (Rockwell hardness: A scale). The edges of these cemented carbide substrates A - E were subjected to hone.

Next, the methods 1 - 15 of the present invention and conventional methods 1 - 10 were executed, respectively and coated cemented carbide tools (hereinafter, coated cemented carbide tools corresponding to the respective methods were referred to as the coated cutting tools of the present invention 1 - 15 and conventional coated cutting tools. 1 - 10) were manufactured by forming hard coated layers having the compositions and target layer thicknesses (at the flank face) shown in Tables 4, 5 using an ordinary chemical vapor deposition device, under the conditions shown in Table 2 (l-TiCN in Table 2 has a longitudinally-grown crystal structure disclosed in Japanese Unexamined Patent Publication No. 6-8010 and p-TiCN in Table 2 has an ordinary grain-shaped crystal structure) and Table 3 (Al₂O₃ (a) - (n) in Table 3 show aluminum oxide layers and Al₂O₃ (o) shows an Al₂O₃ layer, which are also applicable to Tables 4, 5 likewise).

As to each of the aluminum oxide layers and the Al₂O₃ layers (Tables 6, 7 show them as Al₂O₃ layers as a whole) constituting the hard coated layers of the various types of the resultant coated cemented carbide tools, the maximum layer thickness of the cutting edge where a flank face intersected a rake face was measured and further the layer thicknesses on the flank face and the rake face which were located 1 mm inwardly from the cutting edge, respectively were measured. Tables 6, 7 show the result of the measurements.

Note, the layer thicknesses of the layers constituting the hard coated layer other than the aluminum oxide layer and the Al₂O₃ layer had almost no local dispersion and exhibited almost the same values as target layer thicknesses.

In addition, the composition of the elements constituting the aluminum oxide layer of the hard-material-coated cutting tools of the present invention and that of the Al₂O₃ layer of the conventional hard-material-coated cutting tools were analyzed using an EPMA. Note, as to the tools having an outermost layer composed of TiN, the analysis was carried out after the removal of the TiN by hydrogen peroxide water. Further, measurement was carried out by irradiating a circular electron beam with a diameter of 1 mm to the center of a flank face as to tools having the shape regulated by ISO/CNMG120408 and to the center of a rake face as to tools having the shape regulated by ISO/ SEEN42AFTN1.

As a result, the coated cutting tools of the present invention 1 - 15 contained in wt% Al: 47.6 - 49.8%, O: 37.7 - 45.8%, Ti: 4.4 - 10.9%, and Cl: 0.015 - 0.21%. Likewise, the conventional coated cutting tools 1 - 10 contained Al: 52.8 - 53.0%, O: 47.0 - 47.2%, Ti: 0.01 - 0.02%, and Cl: less than measurable limit.

For the purpose of evaluating chipping resistance, the coated cutting tools of the present invention 1 - 3 and the conventional coated cutting tools 1, 2 were subjected to an intermittent cutting test of ductile cast iron under the-following conditions to measure the wear of flank face.
Cutting material: square piece of JIS/FCD450
Cutting speed: 180 m/min.
Cutting depth: 2 mm
Feed rate: 0.3 mm/rev.
Cutting time: 15 minutes

The coated cutting tools of the present invention 4 - 6 and the conventional coated cutting tools 3, 4 were subjected to a dry intermittent cutting test of alloy steel under the following conditions to measure the wear of flank face likewise.
Cutting material: square piece of JIS/SCM440
Cutting speed: 180 m/min.
Cutting depth: 2 mm
Feed rate: 0.3 mm/rev.
Cutting time: 15 minutes

The coated cutting tools of the present invention 7 - 9 and the conventional coated cutting tools 5, 6 were subjected to a dry intermittent cutting test of carbon steel under the following conditions to measure the wear of flank face likewise.
Cutting material: square piece of JIS/S45C
Cutting speed: 180 m/min.
Cutting depth: 2 mm
Feed rate: 0.3 mm/rev.
Cutting time: 15 minutes

The coated cutting tools of the present invention 10 - 12 and the conventional coated cutting tools 7, 8 were subjected to a dry intermittent cutting test of cast iron under the following conditions to measure the wear of flank face likewise.
Cutting material: square piece of JIS/FC200
Cutting speed: 180 m/min.
Cutting depth: 2 mm
Feed rate: 0.3 mm/rev.
Cutting time: 15 minutes

Further, the coated cutting tools of the present invention 13 - 15 and the conventional coated cutting tools 9, 10 were subjected to a dry milling cutting test (intermittent cutting) of alloy steel under the following conditions to measure the wear of flank face likewise.
- Cutting material:: square piece of JIS/SNCM439 with a width of 100 mm and a length of 500 mm
- Using condition:: mounting of single tooth on cutter of 125 mm dia.
Rotation: 510 r.p.m.
Cutting speed: 200 m/min.
Cutting depth: 2 mm
Feed rate: 0.2 mm/tooth
Cutting time: 3 paths (cutting time/path: 5.3 minutes) Tables 6, 7 show the result of these measurements.

### (2) Embodiment 2

Cemented carbide substrates A - E were prepared by the same manufacturing method as that of the embodiment 1. Next, the methods 16 - 30 of the present invention and conventional methods 11 - 20 were executed, respectively and coated cemented carbide tools (hereinafter, coated cemented carbide tools corresponding to the respective methods were referred to as the coated cutting tools of the present invention 16 - 30 and conventional coated cutting tools 11 - 20) were manufactured by forming hard coated layers having the compositions and target layer thicknesses (at the flank face) shown in Tables 9, 10 using an ordinary chemical vapor deposition device under the conditions shown in Table 2 and Table 8 (Al₂O₃ (a) - (n) in Table 8 show aluminum oxide layers and Al₂O₃ (o) shows an Al₂O₃ layer, which are also applicable to Tables 9, 10 likewise).

As to each of the aluminum oxide layers and the Al₂O₃ layers (Tables 11, 12 show them as Al₂O₃ layers as a whole) constituting the hard coated layers of the various types of the resultant coated cutting tools, the maximum layer thickness of the cutting edge where a flank face intersected a rake face was measured and further the layer thicknesses on the flank face and the rake face which were located 1 mm inwardly from the cutting edge, respectively were measured. Tables 11, 12 show the result of the measurements.

Note, the layer thicknesses of the layers constituting the hard coated layer other than the aluminum oxide layer and the Al₂O₃ layer had almost no local dispersion and exhibited almost the same values as target layer thicknesses.

In addition, the composition of the elements constituting the aluminum oxide layer of the coated cutting tools of the present invention and that of the Al₂O₃ layer of the conventional coated cutting tools were analyzed using an EPMA. Elemental analysis was carried out based on the same procedure as Embodiment 1.

As a result, the coated cutting tools of the present invention 16 - 30 contained in wt% Al: 46.5 - 49.9%, O: 37.7 - 45.8%, Ti: 4.1 - 12.1%, and Cl: 0.019 - 0.23%. Likewise, the conventional coated cutting tools 11 - 20 contained Al: 52.8 - 53.0%, O: 47.0 - 47.2%, Ti: 0.01 - 0.02%, and Cl: less than measurable limit.

For the purpose of evaluating chipping resistance, the coated cutting tools of the present invention 16 - 18 and the conventional coated cutting tools 11, 12 were subjected to an intermittent cutting test of ductile cast iron under the following conditions to measure the wear of flank face.
Cutting material: square piece of JIS/FCD450
Cutting speed: 180 m/min.
Cutting depth: 2.5 mm
Feed rate: 0.3 mm/rev.
Cutting time: 15 minutes

The coated cutting tools of the present invention 19 - 21 and the conventional coated cutting tools 13, 14 were subjected to a dry intermittent cutting test of alloy steel under the following conditions to measure the wear of flank face likewise.
Cutting material: square piece of JIS/SCM440
Cutting speed: 180 m/min.
Cutting depth: 2.5 mm
Feed rate: 0.3 mm/rev.
Cutting time: 15 minutes

The coated cutting tools of the present invention 22 - 24 and the conventional coated cutting tools 15, 16 were subjected to a dry intermittent cutting test of carbon steel under the following conditions to measure the wear of flank face likewise.
Cutting material: square piece of JIS/S45C
Cutting speed: 180 m/min.
Cutting depth: 2.5 mm
Feed rate: 0.3 mm/rev.
Cutting time: 15 minutes

The coated cutting tools of the present invention 25 - 27 and the conventional coated cutting tools 17, 18 were subjected to a dry intermittent cutting test of cast iron under the following conditions to measure the wear of flank face likewise.
Cutting material: square piece of JIS/FC200
Cutting speed 180 m/min.
Cutting depth: 2.5 mm
Feed rate: 0.3 mm/rev.
Cutting time: 15 minutes

Further, the coated cutting tools of the present invention 28 - 30 and the conventional coated cutting tools 19, 20 were subjected to a dry milling cutting test (intermittent cutting) of alloy steel under the following conditions to measure the wear of flank face likewise.
- Cutting material:: square piece of JIS/SCM440 with a width of 100 mm and a length of 500 mm
- Using condition:: mounting of single tooth on cutter of 125 mm dia.
Rotation: 510 r.p.m.
Cutting speed: 200 m/min.
Cutting depth: 2 mm
Feed rate: 0.2 mm/tooth
Cutting time: 3 paths (cutting time/path: 5.3 minutes) Tables 11, 12 show the result of these measurements.

### (3) Embodiment 3

Cemented carbide substrates A - E were prepared by the same manufacturing method as that of the embodiment 1. Next, the methods 31 - 44 of the present invention and conventional methods 21 - 30 were executed, respectively and coated cemented carbide tools (hereinafter, coated cemented carbide tools corresponding to the respective methods were referred to as the coated cutting tools of the present invention 31 - 44 and conventional coated cutting tools 21 - 30) were manufactured by forming hard coated layers having the compositions and target layer thicknesses (at the flank face) shown in Tables 14, 15 using an ordinary chemical vapor deposition device, under the conditions shown in Table 2 and Table 13 (Al₂O₃ (a) - (l) in Table 13 show aluminum oxide layers and Al₂O₃ (m shows an Al₂O₃ layer, which are also applicable to Tables 14, 15 likewise).

As to each of the aluminum oxide layers and the Al₂O₃ layers (Tables 16, 17 show them as Al₂O₃ layers as a whole) constituting the hard coated layers of the various types of the resultant coated cutting tools, the maximum layer thickness of the cutting edge where a flank face intersected a rake face was measured and further the layer thicknesses on the flank face and the rake face which were located 1 mm inwardly from the cutting edge, respectively were measured. Tables 16, 17 show the result of the measurements.

Note, the layer thicknesses of the layers constituting the hard coated layer other than the aluminum oxide layer and the Al₂O₃ layer had almost no local dispersion and exhibited almost the same values as target layer thicknesses.

In addition, the composition of the elements constituting the aluminum oxide layer of the coated cutting tools of the present invention and that of the Al₂O₃ layer of the conventional coated cutting tools were analyzed using an EPMA. Elemental analysis was carried out based on the same procedure as Embodiment 1.

As a result, the coated cutting tools of the present invention 31 - 44 contained in wt% Al: 46.6 - 47.8%, O: 35.5 - 42.8%, Ti: 6.5 - 14.3%, and Cl: 0.11 - 0.46%. Likewise, the conventional coated cutting tools 21 - 30 contained Al: 52.8 - 53.0%, O: 47.0 - 47.2%, Ti: 0.01 - 0.02%, and Cl: less than measurable limit.

For the purpose of evaluating chipping resistance, the coated cutting tools of the present invention 31 - 36 and the conventional coated cutting tools 21, 22 were subjected to an intermittent cutting test of mild steel under the following conditions to measure the wear of flank face.
Cutting material: square piece of mild steel
Cutting speed: 220 m/min.
Cutting depth: 1.5 mm
Feed rate: 0.18 mm/rev.
Cutting time: 20 minutes

The coated cutting tools of the present invention 37 - 38 and the conventional coated cutting tools 23, 24 were subjected to a dry intermittent cutting test of ductile cast iron under the following conditions to measure the wear of flank face.
Cutting material: square piece of JIS/FCD450
Cutting speed: 150 m/min.
Cutting depth: 2 mm
Feed rate: 0.3 mm/rev.
Cutting time: 15 minutes

The coated cutting tools of the present invention 39, 40 and the conventional coated cutting tools 25, 26 were subjected to a dry intermittent cutting test of alloy steel under the following conditions to measure the wear of flank face likewise.
Cutting material: square piece of JIS/SNCM439
Cutting speed: 150 m/min.
Cutting depth: 2 mm
Feed rate: 0.3 mm/rev.
Cutting time: 15 minutes

The coated cutting tools of the present invention 41, 42 and the conventional coated cutting tools 27, 28 were subjected to a dry intermittent cutting test of carbon steel under the following conditions to measure the wear of flank face likewise.
Cutting material: square piece of JIS/S45C
Cutting speed: 150 m/min.
Cutting depth: 2 mm
Feed rate: 0.3 mm/rev.
Cutting time: 15 minutes

Further, the coated cutting tools of the present invention 43, 44 and the conventional coated cutting tools 29, 30 were subjected to a dry milling cutting test (intermittent cutting) of mild steel under the following conditions to measure the wear of flank face likewise.
- Cutting material:: square piece of mild steel with a width of 100 mm and a length of 500 mm
- Using condition:: mounting of single tooth on cutter of 125 mm dia.
Rotation: 600 r.p.m.
Cutting speed: 280 m/min.
Cutting depth: 2 mm
Feed rate: 0.24 mm/tooth
Cutting time: 7. paths (cutting time/path: 3.6 minutes) Tables 16, 17 show the result of these measurements.

### (4) Embodiment 4

Cemented carbide substrates A - E were prepared by the same manufacturing method as that of the embodiment 1. Next, the methods 46 - 60 (45 lacked) of the present invention and conventional methods 31 - 40 were executed, respectively and coated cemented carbide tools (hereinafter, coated cemented carbide tools corresponding to the respective methods were referred to as the coated cutting tools of the present invention 46 - 60 and conventional coated cutting tools 31 - 40) were manufactured by forming hard coated layers having the compositions and target layer thicknesses (at the flank face) shown in Tables 19, 20 using an ordinary chemical vapor deposition device, under the conditions shown in Table 2 and Table 18 (Al₂O₃ (a) - (1) in Table 18 show aluminum oxide layers and Al₂O₃ (m) shows an Al₂O₃ layer, which are also applicable to Tables 19, 20 likewise).

As to each of the aluminum oxide layers and the Al₂O₃ layers (Tables 21, 22 show them as Al₂O₃ layers as a whole) consisting the hard coated layers of the various types of the resultant coated cutting tools, the maximum layer thickness of the cutting edge where a flank face intersected a rake face was measured and further the layer thicknesses on the flank face and the rake face which were located 1 mm inwardly from the cutting edge, respectively were measured. Tables 21, 22 show the result of the measurements.

Note, the layer thicknesses of the layers constituting the hard coated layer other than the aluminum oxide layer and the Al₂O₃ layer had almost no local dispersion and exhibited almost the same values as target layer thicknesses.

In addition, the composition of the elements constituting the aluminum oxide layer of the coated cutting tools of the present invention and that of the Al₂O₃ layer of the conventional coated cutting tools were analyzed using an EPMA. Elemental analysis was carried out based on the same procedure as Embodiment 1.

As a result, the coated cutting tools of the present invention 46 - 60 contained in wt% Al: 44.3 - 47.9%, O: 35.1 - 42.7%, Ti: 5.9 - 14.7%, and Cl: 0.14 - 0.41%. Likewise, the conventional coated cutting tools 31 - 40 contained Al: 52.8 - 53.0%, O: 47.0 - 47.2%, Ti: 0.01 - 0.02%, and Cl: less than measurable limit.

For the purpose of evaluating chipping resistance, the coated cutting tools of the present invention 46 - 48 and the conventional coated cutting tools 31, 32 were subjected to an intermittent cutting test of ductile cast iron under the following conditions to measure the wear of flank face.
Cutting material: square piece of JIS/FCD450
Cutting speed: 180 m/min.
Cutting depth: 3 mm
Feed rate: 0.2 mm/rev.
Cutting time: 15 minutes

The coated cutting tools of the present invention 49 - 51 and the conventional coated cutting tools 33, 34 were subjected to a dry intermittent cutting test of alloy steel under the following conditions to measure the wear of flank face likewise.
Cutting material: square piece of JIS/SNCM439
Cutting speed: 180 m/min.
Cutting depth: 3 mm
Feed rate: 0.2 mm/rev.
Cutting time: 15 minutes

The coated cutting tools of the present invention 52 - 54 and the conventional coated cutting tools 35, 36 were subjected to a dry intermittent cutting test of carbon steel under the following conditions to measure the wear of flank face likewise.
Cutting material: square piece of JIS/S30C
Cutting speed: 180 m/min.
Cutting depth: 3 mm
Feed rate: 0.2 mm/rev.
Cutting time: 15 minutes

The coated cutting tools of the present invention 55 - 57 and the conventional coated cutting tools 37, 38 were subjected to a dry intermittent cutting test of cast iron under the following conditions to measure the wear of flank face likewise.
Cutting material: square piece of JIS/FC300
Cutting speed: 180 m/min.
Cutting depth: 3 mm
Feed rate: 0.2 mm/rev.
Cutting time: 15 minutes

Further, the coated cutting tools of the present invention 58 - 60 and the conventional coated cutting tools 39, 40 were subjected to a dry milling cutting test (intermittent cutting) of alloy steel under the following conditions to measure the wear of flank face likewise.
- Cutting material:: square piece of JIS/SNCM439 with a width of 100 mm and a length of 500 mm
- Using condition:: mounting of single tooth on cutter of 125 mm dia.
Rotation: 510 r.p.m.
Cutting speed: 200 m/min.
Cutting depth: 2 mm
Feed rate: 0.2 mm/tooth
Cutting time: 3 paths (cutting time/path: 5.3 minutes) Tables 21, 22 show the result of these measurements.

### (5) Embodiment 5

Cemented carbide substrates A - E were prepared by the same manufacturing method as that of the embodiment 1. Next, the methods 61 - 75 of the present invention and conventional methods 41 - 50 were executed, respectively and coated cemented carbide tools (hereinafter, coated cemented carbide tools corresponding to the respective methods were referred to as the coated cutting tools of the present invention 61 - 75 and conventional coated cutting tools 41 - 50) were manufactured by forming hard coated layers having the compositions and target layer thicknesses (at the flank face) shown in Tables 24, 25 using an ordinary chemical vapor deposition device, under the conditions shown in Table 2 and Table 23 (Al₂O₃ (a) - (n) in Table 23 show aluminum oxide layers, which is also applicable to Tables 24, 25 likewise).

As to each of the aluminum oxide layers and the Al₂O₃ layers (Tables 26, 27 show them as Al₂O₃ layers as a whole) constituting the hard coated layers of the various types of the resultant coated cutting tools, the maximum layer thickness of the cutting edge where a flank face intersected a rake face was measured and further the layer thicknesses on the flank face and the rake face which were located 1 mm inwardly from the cutting edge, respectively were measured. Tables 26, 27 show the result of the measurements.

Note, the layer thicknesses of the layers constituting the hard coated layer other than the aluminum oxide layer and the Al₂O₃ layer had almost no local dispersion and exhibited almost the same values as target layer thicknesses.

In addition, the composition of the elements constituting the aluminum oxide layer of the coated cutting tools of the present invention and that of the Al₂O₃ layer of the conventional coated cutting tools were analyzed using an EPMA. Elemental analysis was carried out based on the same procedure as Embodiment 1.

As a result, the coated cutting tools of the present invention 61 - 75 contained in wt% Al: 52.8 - 53.1%, 0: 46.5 - 46.9%, and Cl: 0.13 - 0.36%. Likewise, the conventional coated cutting tools 41 - 50 contained Al: 52.8 - 53.0%, O: 47.0 - 47.2%, Ti: 0.01 - 0.02%, and Cl: less than measurable limit.

For the purpose of evaluating chipping resistance, the coated cutting tools of the present invention 61 - 63 and the conventional coated cutting tools 41, 42 were subjected to an intermittent cutting test of ductile cast iron under the following conditions to measure the wear of flank face.
Cutting material: square piece of JIS/FCD450
Cutting speed: 200 m/min.
Cutting depth: 1.5 mm
Feed rate: 0.35 mm/rev.
Cutting time: 15 minutes

The coated cutting tools of the present invention 64 - 66 and the conventional coated cutting tools 43, 44 were subjected to a dry intermittent cutting test of alloy steel under the following conditions to measure the wear of flank face likewise.
Cutting material: square piece of JIS/SCM440
Cutting speed: 200 m/min.
Cutting depth: 1.5 mm
Feed rate: 0.35 mm/rev.
Cutting time: 15 minutes

The coated cutting tools of the present invention 67 - 69 and the conventional coated cutting tools 45, 46 were subjected to a dry intermittent cutting test of carbon steel under the following conditions to measure the wear of flank face likewise.
Cutting material: square piece of JIS/S45C
Cutting speed: 200 m/min.
Cutting depth: 1.5 mm
Feed rate: 0.35 mm/rev.
Cutting time: 15 minutes

The coated cutting tools of the present invention 70 - 72 and the conventional coated cutting tools 47, 48 were subjected to a dry intermittent cutting test of cast iron under the following conditions to measure the wear of flank face likewise.
Cutting material: square piece of JIS/FC200
Cutting speed: 200 m/min.
Cutting depth: 1.5 mm
Feed rate: 0.35 mm/rev.
Cutting time: 15 minutes

Further, the coated cutting tools of the present invention 73 - 75 and the conventional coated cutting tools 49, 50 were subjected to a dry milling cutting test (intermittent cutting) of alloy steel under the following conditions to measure the wear of flank face likewise.
- Cutting material:: square piece of JIS/SNCM439 with a width of 100 mm and a length of 500 mm
- Using condition:: mounting of single tooth on cutter of 125 mm dia.
Rotation: 380 r.p.m.
Cutting speed: 150 m/min.
Cutting depth: 2 mm
Feed rate: 0.25 mm/tooth
Cutting time: 2 paths (cutting time/path: 5.5 minutes) Tables 26, 27 show the result of these measurements.

### (6) Embodiment 6

Cemented carbide substrates A - E were prepared by the same manufacturing method as that of the embodiment 1. Next, the methods 76 - 85 of the present invention and conventional methods 51 - 60 were executed, respectively and coated cemented carbide tools (hereinafter, coated cemented carbide tools corresponding to the respective methods were referred to as the coated cutting tools of the present invention 76 - 85 and conventional coated cutting tools 51 - 60) were manufactured by forming hard coated layers having the compositions and target layer thicknesses (at the flank face) shown in Tables 29, 30 using an ordinary chemical vapor deposition device. Under the conditions shown in Table 2 and Table 28 (Al₂O₃ (a) - (i) in Table 28 show aluminum oxide layers and Al₂O₃ (j shows an Al₂O₃ layer, which are also applicable to Tables 29, 30 likewise).

As to each of the aluminum oxide layers and the Al₂O₃ layers (Tables 31, 32 show them as Al₂O₃ layers as a whole) constituting the hard coated layers of the various types of the resultant coated cutting tools, the maximum layer thickness of the cutting edge where a flank face intersected a rake face was measured and further the layer thicknesses on the flank face and the rake face which were located 1 mm inwardly from the cutting edge, respectively were measured. Tables 31, 32 show the result of the measurements.

Note, the layer thicknesses of the layers constituting the hard coated layer other than the aluminum oxide layer and the Al₂O₃ layer had almost no local dispersion and exhibited almost the same values as target layer thicknesses.

In addition, the composition of the elements constituting the aluminum oxide layer of the coated cutting tools of the present invention and that of the Al₂O₃ layer of the conventional coated cutting tools were analyzed using an EPMA. Elemental analysis was carried out based on the same procedure as Embodiment 1.

As a result, the coated cutting tools of the present invention 76 - 85 contained in wt% Al: 52.9 - 53.1%, O: 46.4 - 46.7%, and Cl: 0.45 - 0.47%. Likewise, the conventional coated cutting tools 51 - 60 contained Al: 52.8 - 53.0%, O: 47.0 - 47.2%, Ti: 0.01 - 0.02%, and Cl: less than measurable limit.

For the purpose of evaluating chipping resistance, the coated cutting tools of the present invention 76, 77 and the conventional coated cutting tools 51, 52 were subjected to an intermittent cutting test of ductile cast iron under the following conditions to measure the wear of flank face.
Cutting material: square piece of JIS/FCD450
Cutting speed: 200 m/min.
Cutting depth: 1.5 mm
Feed rate: 0.3 mm/rev.
Cutting time: 15 minutes

The coated cutting tools of the present invention 78, 79 and the conventional coated cutting tools 53, 54 were subjected to a dry intermittent cutting test of alloy steel under the following conditions to measure the wear of flank face likewise.
Cutting material: square piece of JIS/SCM440
Cutting speed: 200 m/min.
Cutting depth: 1.5 mm
Feed rate: 0.3 mm/rev.
Cutting time: 15 minutes

The coated cutting tools of the present invention 80, 81 and the conventional coated cutting tools 55, 56 were subjected to a dry intermittent cutting test of carbon steel under the following conditions to measure the wear of flank face) likewise.
Cutting material: square piece of JIS/S45C
Cutting speed: 200 m/min.
Cutting depth: 1.5 mm
Feed rate: 0.3 mm/rev.
Cutting time: 15 minutes

The coated cutting tools of the present invention 82, 83 and the conventional coated cutting tools 57, 58 were subjected to a dry intermittent cutting test of cast iron under the following conditions to measure the wear of flank face likewise.
Cutting material: square piece of JIS/FC200
Cutting speed: 200 m/min.
Cutting depth: 1.5 mm
Feed rate: 0.3 mm/rev.
Cutting time: 15 minutes

Further, the coated cutting tools of the present invention 84, 85 and the conventional coated cutting tools 59, 60 were subjected to a dry milling cutting test (intermittent cutting) of alloy steel under the following conditions to measure the wear of flank face likewise.
- Cutting material:: square piece of JIS/SNCM439 with a width of 100 mm and a length of 500 mm
- Using condition:: mounting of single tooth on cutter of 125 mm dia.
Rotation: 380 r.p.m.
Cutting speed: 150 m/min.
Cutting depth: 2 mm
Feed rate: 0.2 mm/tooth
Cutting time: 2 paths (cutting time/path: 7 minutes Tables 31, 32 show the result of these measurements.

It is apparent from the result shown above that the coated cutting tools made by the method of the present invention, in which the aluminum oxide layer constituting the hard coated layers is formed using the inert gas type reaction gas, have very small amount of local dispersion in the aluminum oxide layer among the hard coated layers constituting the tools even if the layer is formed as relatively thick and the layer thicknesses of the flank face and the rake face of a cutting portion and the cutting edge where the flank face intersects the rake face are made uniform, whereas the conventional coated cutting tools made by the conventional method using the reaction gas in hydrogen ambient for the formation of the Al₂O₃ layer have a great amount of dispersion of the layer thicknesses in a flank face, a rake face, and a cutting edge, thus the coated cutting tools of the present invention exhibit excellent chipping resistance in the intermittent cutting of steel and cast iron as compared with that of the conventional coated cutting tools.

As described above, according to the method of the present invention, there can be made the coated cutting tools in which even if the layer thickness of the aluminum oxide layer constituting the hard coated layer is increased, the layer thickness has a very small amount of local dispersion. Consequently, the above aluminum oxide layer of the resultant coated cutting tools has the same characteristics as those of the Al₂O₃ layer as well as the tools exhibit excellent chipping resistance not only in the continuous cutting but also in the intermittent cutting of, for example, steel and cast iron and achieve an excellent cutting performance for a long time. Therefore, the present invention provides useful industrial advantage such as the contribution to the automatic cutting operation and labor cost saving in factories.

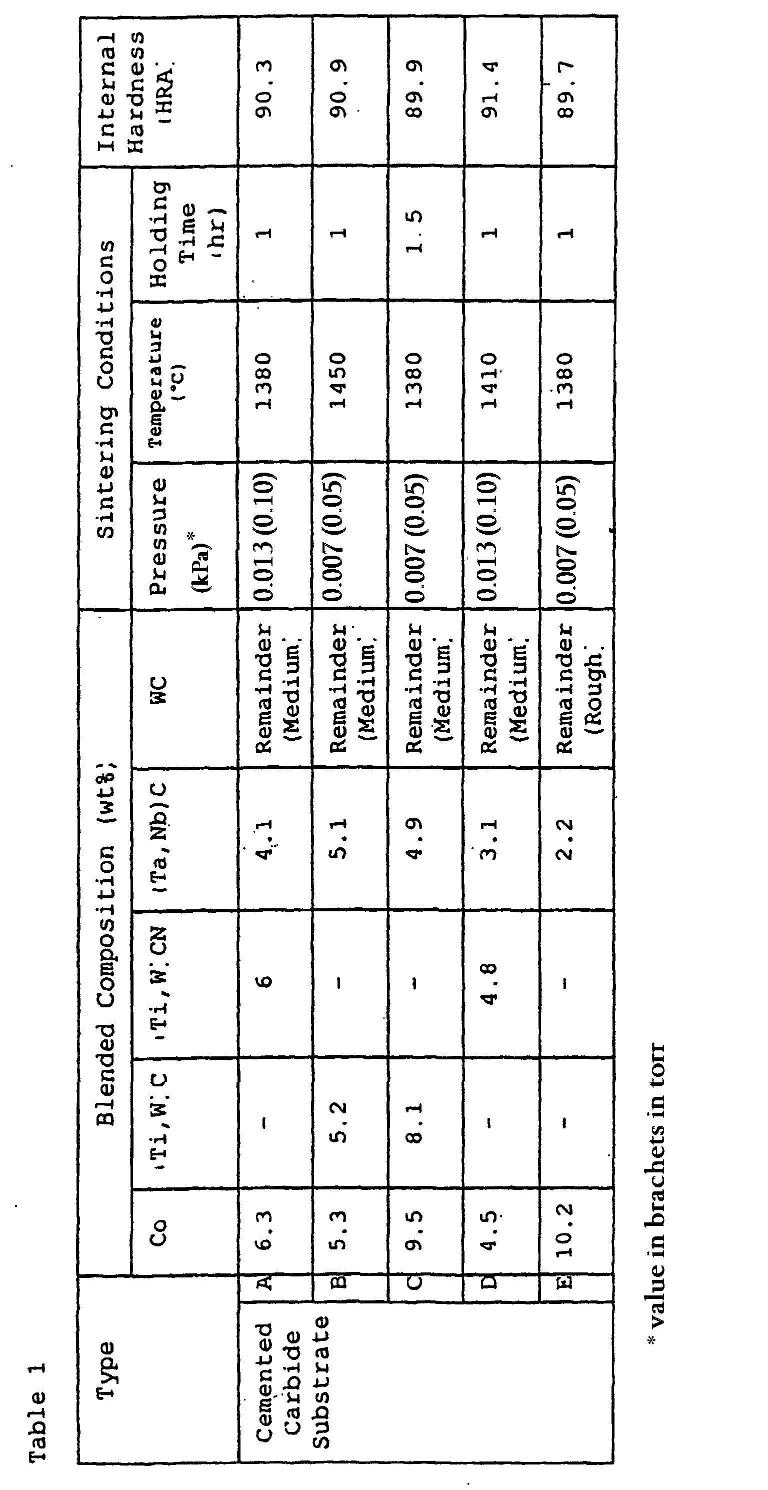

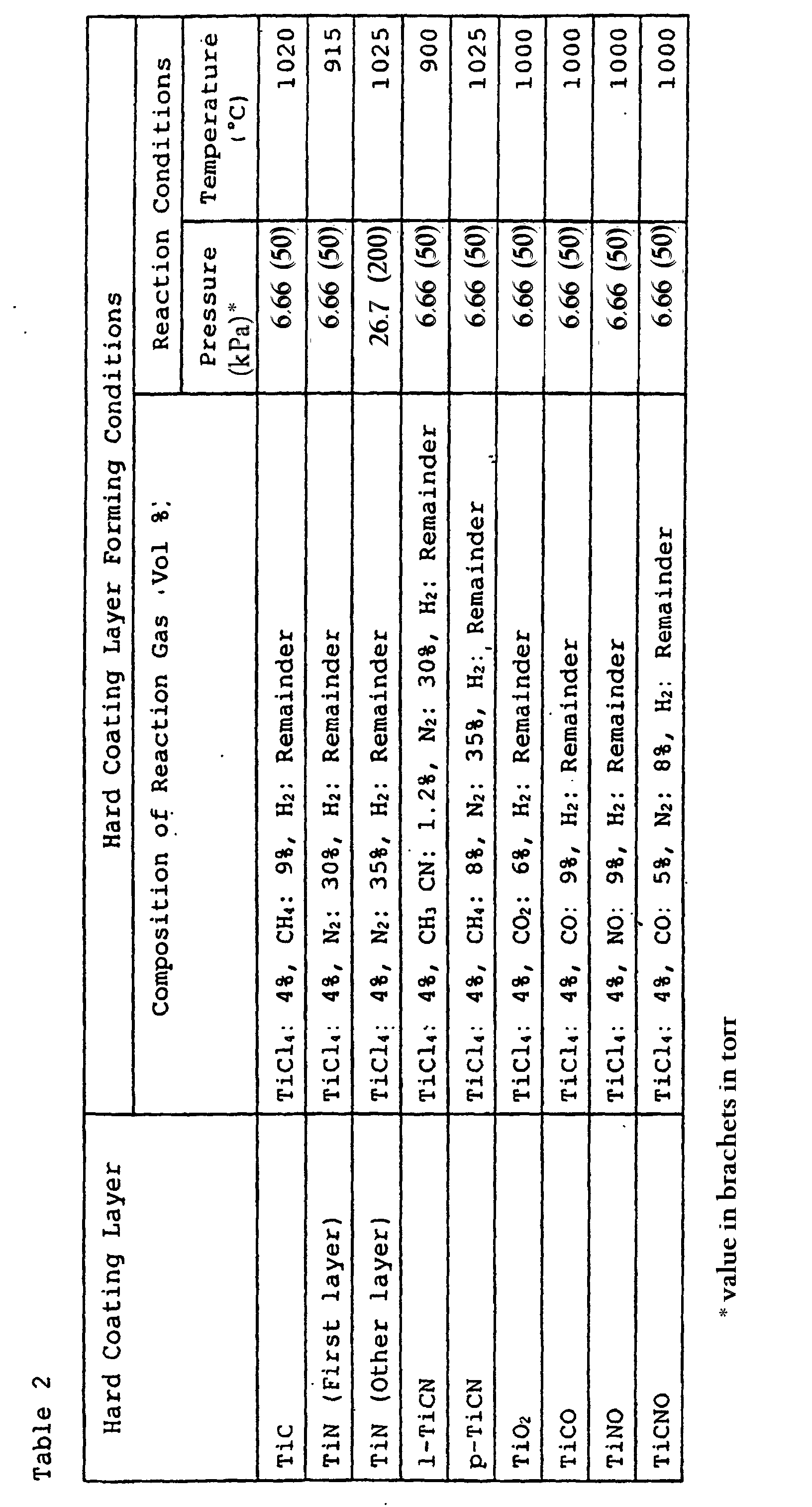

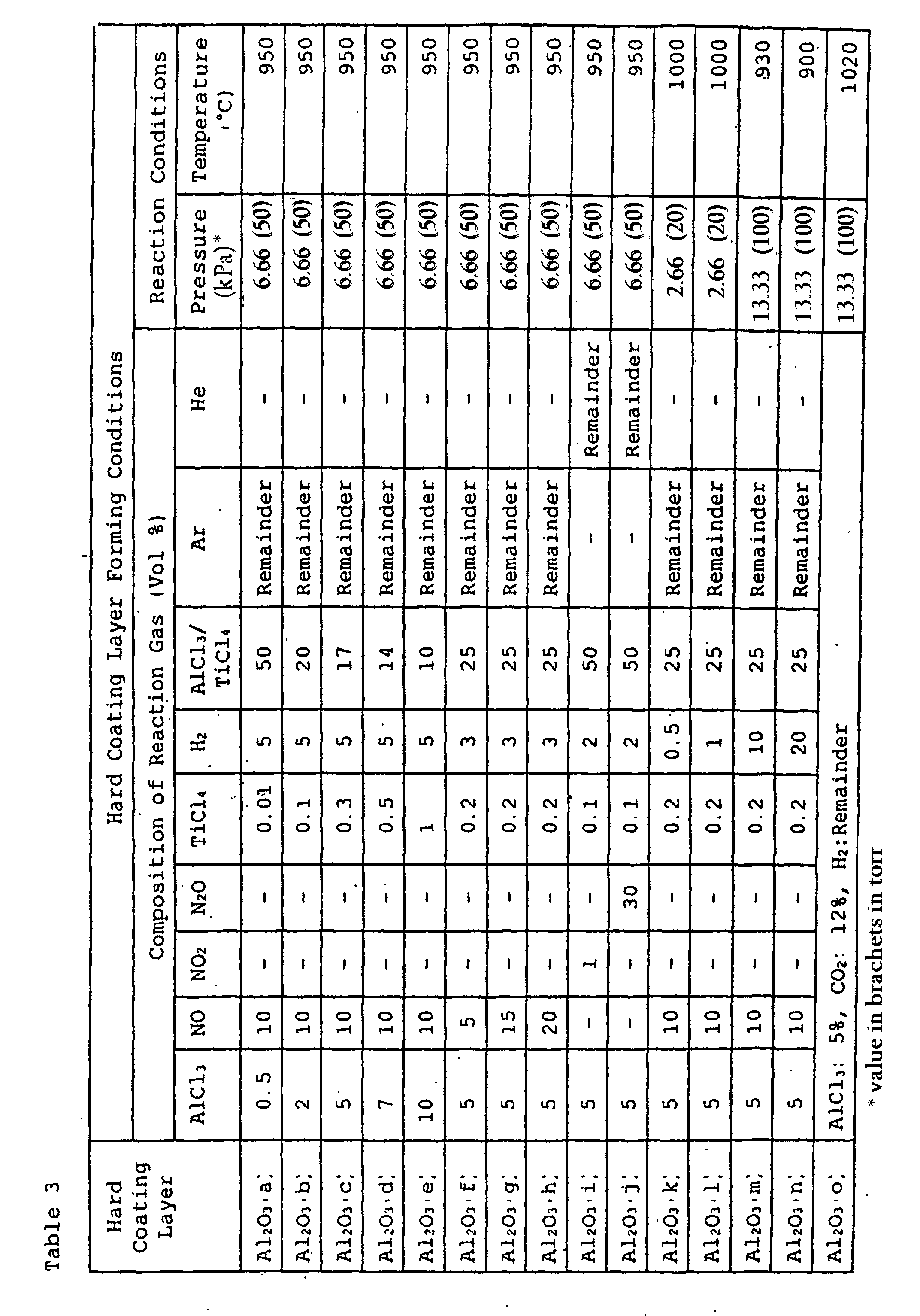

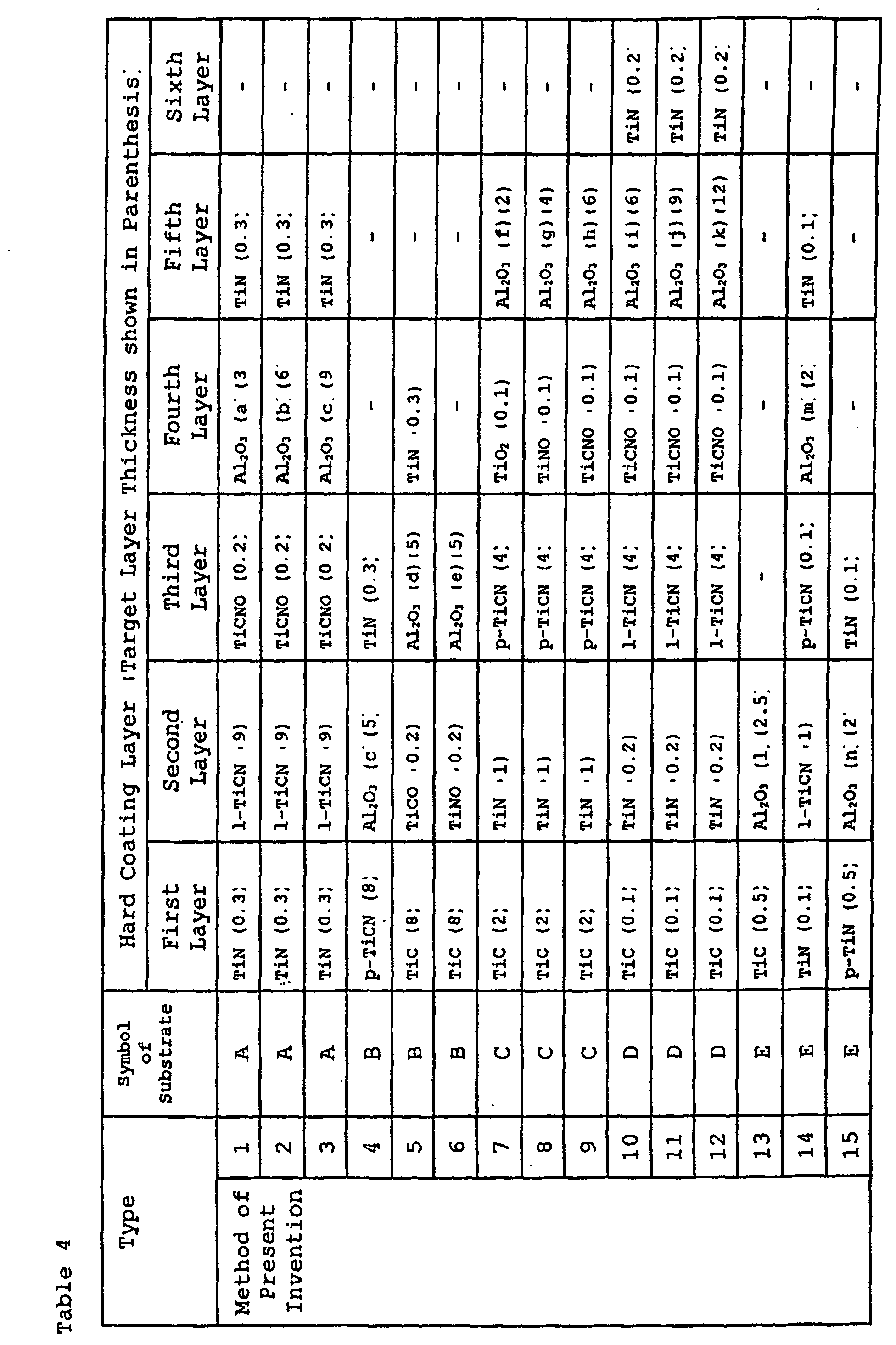

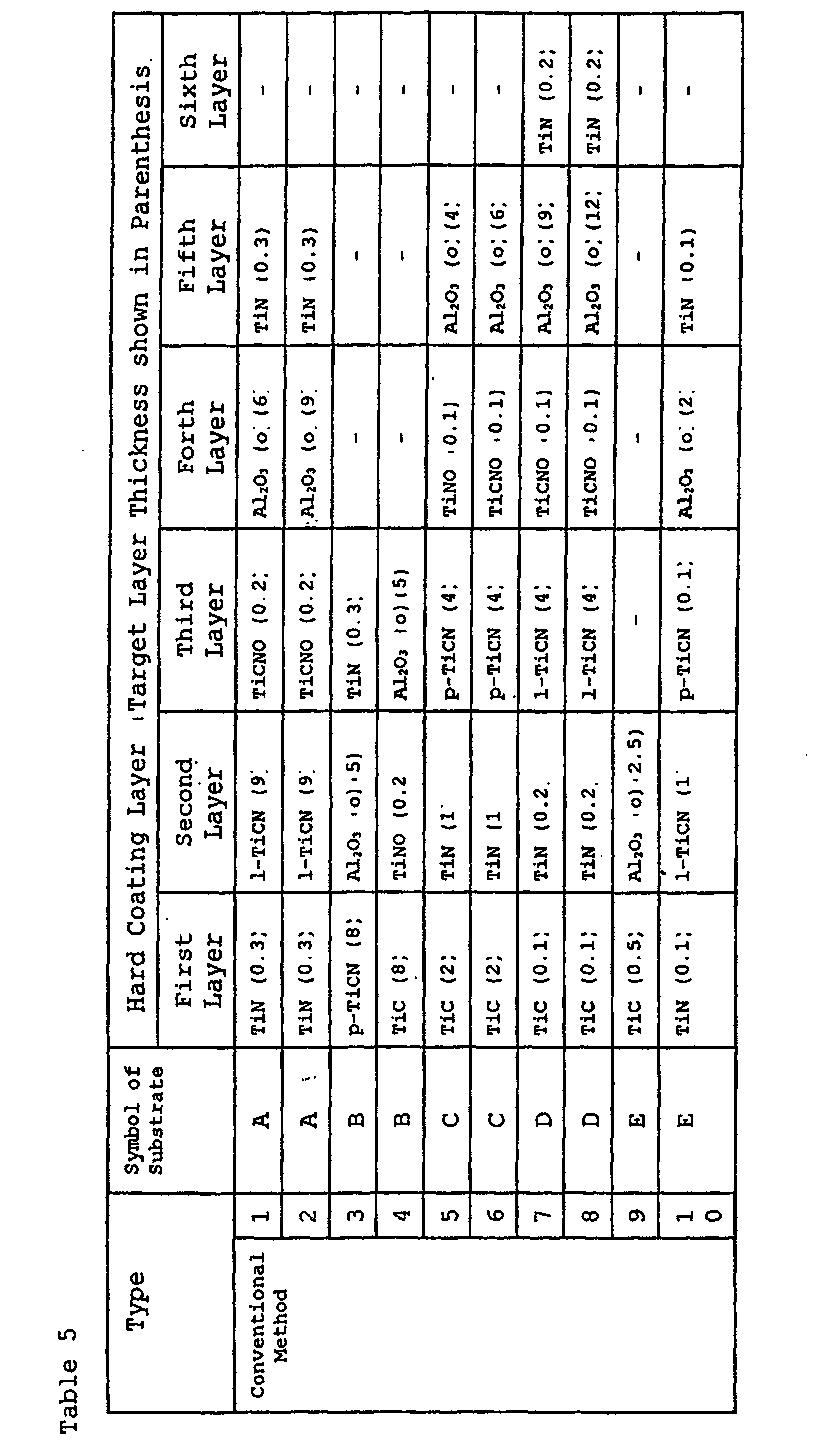

**Table 6**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Hard-Material-Coated Cemented Carbide Cutting Tool of Present Invention | 1 | 3.0 | 3.5 | 2.8 | 0.21 |
| | 2 | 6.0 | 6.9 | 5.8 | 0.26 |
| | 3 | 9.0 | 10.4 | 8.5 | 0.27 |
| | 4 | 5.1 | 6.0 | 5.0 | 0.23 |
| | 5 | 5.0 | 5.7 | 4.6 | 0.23 |
| | 6 | 5.0 | 5.6 | 4.7 | 0.22 |
| | 7 | 2.0 | 2.3 | 1.9 | 0.20 |
| | 8 | 4.0 | 4.5 | 3.9 | 0.21 |
| | 9 | 5.9 | 7.0 | 5.6 | 0.22 |
| | 10 | 6.0 | 6.9 | 5.9 | 0,28 |
| | 11 | 9.0 | 10.5 | 8.6 | 0.30 |
| | 12 | 12.1 | 14.0 | 11.3 | 0.31 |
| | 13 | 2.5 | 2.9 | 2.4 | 0.19 |
| | 14 | 2.0 | 2.2 | 1.9 | 0.19 |
| | 15 | 2.0 | 2.3 | 2.0 | 0.20 |

**Table 7**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Conventional Hard-Material-Coated Cemented Carbide Cutting Tool | 1 | 6.0 | 10.1 | 2.6 | Usable Life Finished in 2.5 min. |
| | 2 | 8.8 | 15.1 | 3.9 | Usable Life Finished in 3.0 min. |
| | 3 | 4.8 | 10.0 | 2.2 | Usable Life Finished in 4.5 min. |
| | 4 | 4.9 | 9.1 | 2.5 | Usable Life Finished in 4.5 min. |
| | 5 | 3.9 | 6.9 | 2.0 | Usable Life Finished in 6.5 min. |
| | 6 | 6.0 | 10.3 | 3.1 | Usable Life Finished in 8.0 min. |
| | 7 | 8.7 | 15.1 | 4.1 | Usable Life Finished in 2.0 min. |
| | 8 | 11.5 | 20.4 | 4.9 | Usable Life Finished in 2.5 min. |
| | 9 | 2.5 | 4.1 | 1.3 | Usable Life Finished in 11.5 min. |
| | 10 | 2.0 | 3.9 | 1.2 | Usable Life Finished in 8.0 min. |
| (Usable life is finished due to chipping.) | | | | | |

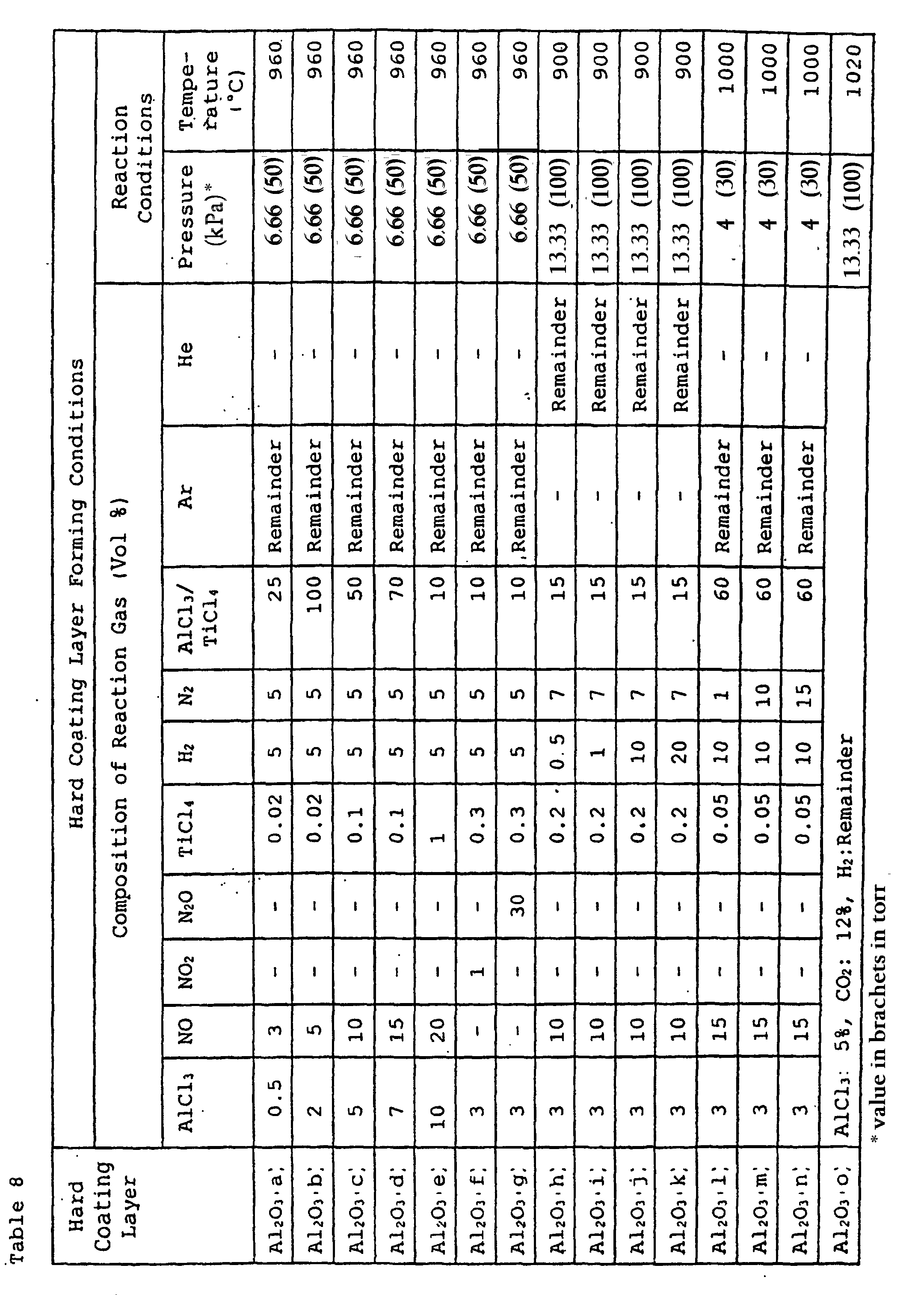

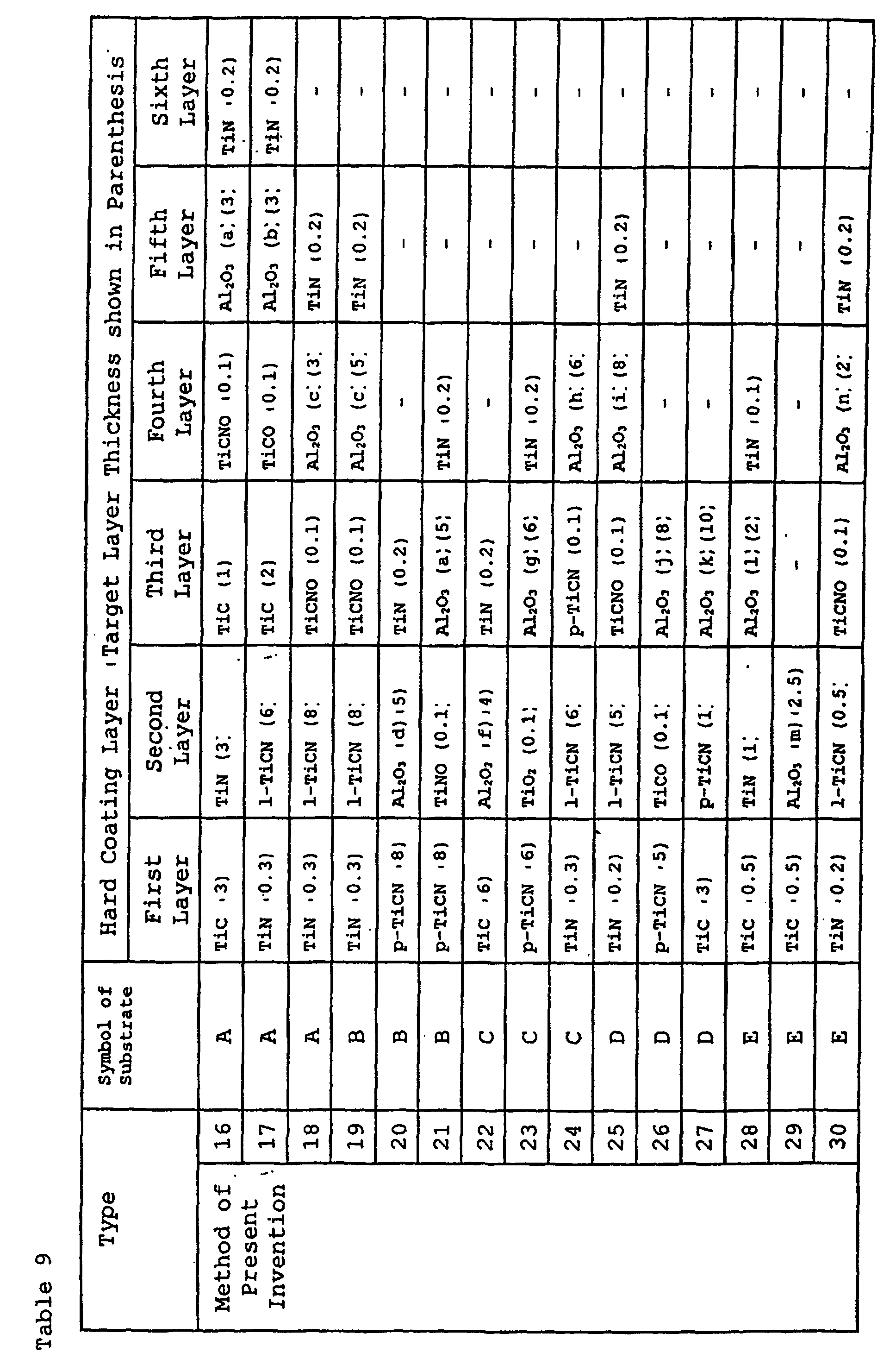

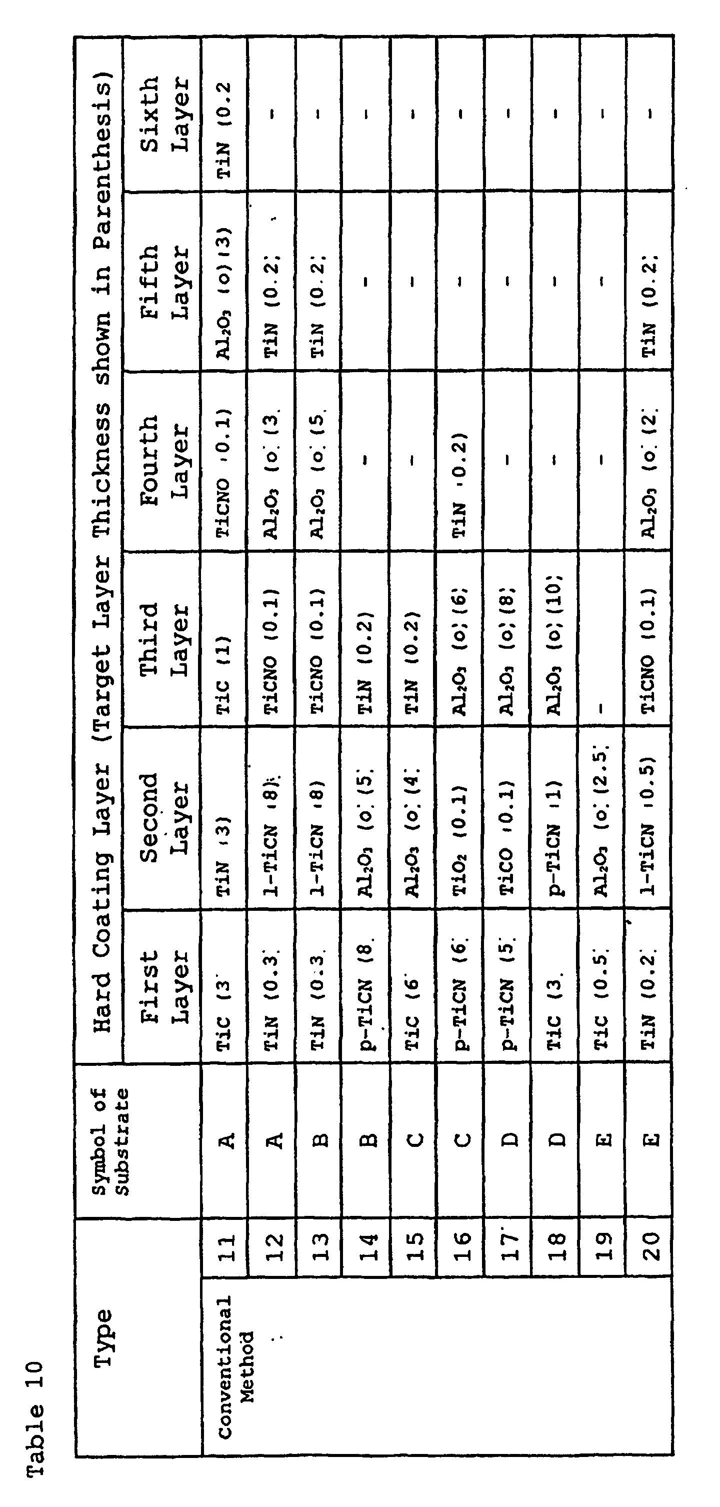

**Table 11**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Hard-Material-Coated Cemented Carbide Cutting Tool of Present Invention | 16 | 3.0 | 3.3 | 2.8 | 0.27 |
| | 17 | 3.0 | 3.4 | 2.7 | 0.23 |
| | 18 | 3.0 | 3.4 | 2.8 | 0.26 |
| | 19 | 4.9 | 5.7 | 4.6 | 0.26 |
| | 20 | 5.0 | 5.7 | 4.6 | 0.22 |
| | 21 | 5.0 | 5.7 | 4.8 | 0.27 |
| | 22 | 4.0 | 4.6 | 3.9 | 0.27 |
| | 23. | 6.1 | 6.9 | 5.7 | 0.27 |
| | 24 | 6.1 | 6.9 | 5.8 | 0.26 |
| | 25 | 8.1 | 9.3 | 7.5 | 0.25 |
| | 26 | 8.0 | 9.0 | 7.7 | 0.26 |
| | 27 | 10.0 | 11.5 | 9.4 | 0.29 |
| | 28 | 2.0 | 2.2 | 1.9 | 0.24 |
| | 29 | 2.5 | 3.0 | 2.4 | 0.26 |
| | 30 | 2.0 | 2.3 | 1.9 | 0.24 |

**Table 12**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Conventional Hard-Material-Coated Cement Carbide Cutting Tool | 11 | 3.0 | 4.6 | 1.5 | Usable Life Finished in 4.5 min. |
| | 12 | 3.0 | 4.5 | 1.3 | Usable Life Finished in 4.0 min. |
| | 13 | 4.8 | 8.2 | 2.4 | Usable Life Finished in 2.0 min. |
| | 14 | 4.9 | 8.0 | 3.0 | Usable Life Finished in 2.5 min. |
| | 15 | 3.9 | 7.7 | 2.1 | Usable Life Finished in 6.5 min. |
| | 16 | 6.0 | 10.3 | 2.4 | Usable Life Finished in 7.5 min. |
| | 17 | 7.8 | 14.1 | 4.0 | Usable Life Finished in 3.0 min. |
| | 18 | 9.8 | 18.9 | 4.4 | Usable Life Finished in 5.5 min. |
| | 19 | 2.5 | 4.2 | 1.2 | Usable Life Finished in 7.5 min. |
| | 20 | 1.9 | 3.4 | 0.9 | Usable Life Finished in 8.0 min. |
| (Usable life is finished due to chipping.) | | | | | |

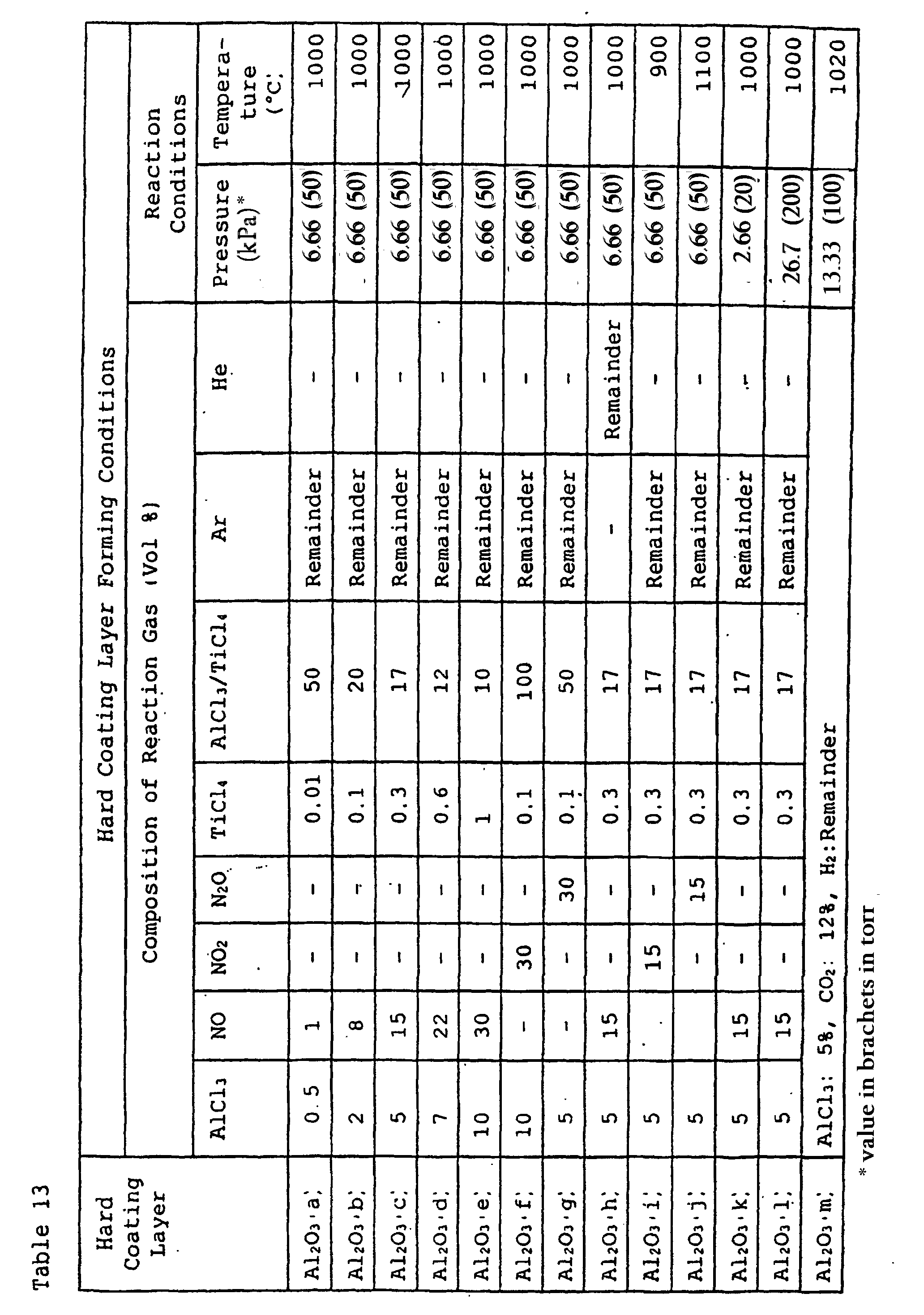

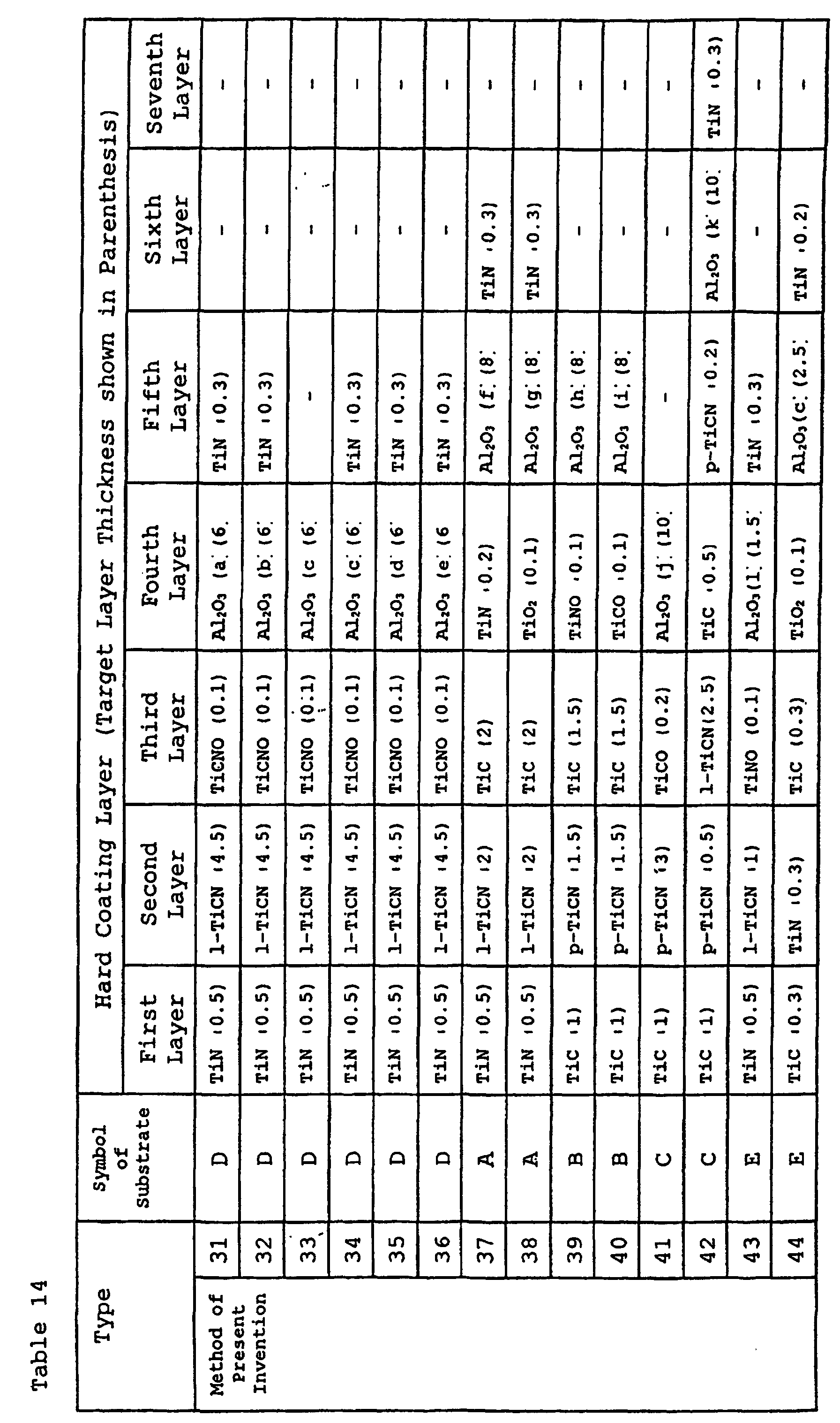

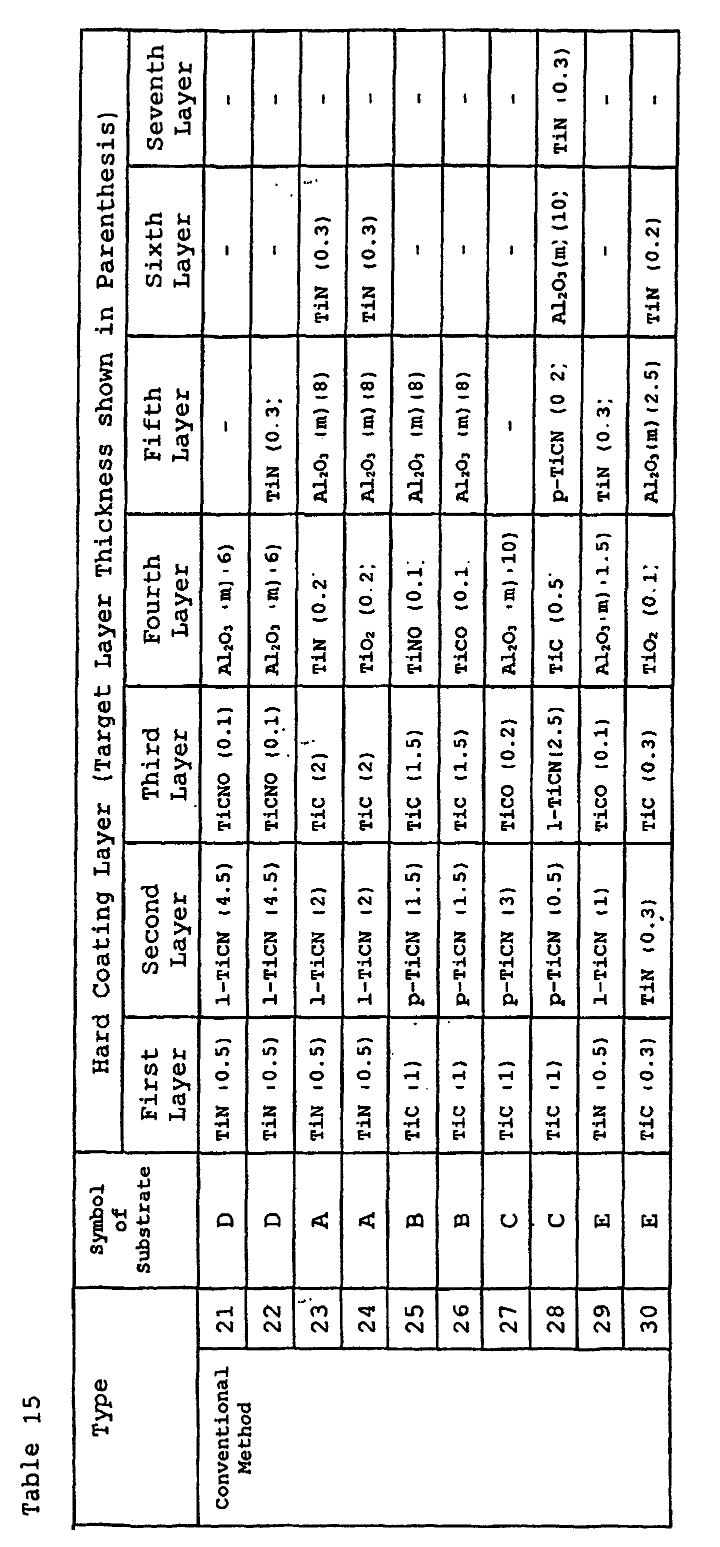

**Table 16**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Hard-Material-Coated Cemented Carbide Cutting Tool of Present Invention | 31 | 5.9 | 7.0 | 5.4 | 0.19 |
| | 32 | 5.8 | 6.8 | 5.4 | 0.19 |
| | 33 | 6.1 | 6.9 | 6.0 | 0.18 |
| | 34 | 6.2 | 7.0 | 6.0 | 0.17 |
| | 35 | 6.2 | 7.3 | 6.0 | 0.17 |
| | 36 | 6.2 | 7.3 | 5.8 | 0.18 |
| | 37 | 8.2 | 9.5 | 7.7 | 0.26 |
| | 38 | 7.9 | 9.2 | 7.3 | 0.25 |
| | 39 | 8.0 | 9.1 | 7.6 | 0.30 |
| | 40 | 7.8 | 9.0 | 7.3 | 0.27 |
| | 41 | 10.2 | 12.0 | 9.6 | 0.21 |
| | 42 | 9.9 | 11.6 | 9.6 | 0.23 |
| | 43 | 1.5 | 1.8 | 1.5 | 0.20 |
| | 44 | 2.5 | 3.0 | 2.4 | 0.18 |

**Table 17**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Conventional Hard-Material-Coated Cement Carbide Cutting Tool | 21 | 6.2 | 15.0 | 2.9 | Usable Life Finished in 1.5 min. |
| | 22 | 6.0 | 14.5 | 2.8 | Usable Life Finished in 2.2 min. |
| | 23 | 7.8 | 19.1 | 3.3 | Usable Life Finished in 7.0 min. |
| | 24 | 8.1 | 20.0 | 3.7 | Usable Life Finished in 5.8 min. |
| | 25 | 8.2 | 19.8 | 3.6 | Usable Life Finished in 9.0 min. |
| | 26 | 8.1 | 19.7 | 3.5 | Usable Life Finished in 6.5 min. |
| | 27 | 10.1 | 25.2 | 4.5 | Usable Life Finished in 11.2 min. |
| | 28 | 10.3 | 25.5 | 4.6 | Usable Life Finished in 11.0 min. |
| | 29 | 1.5 | 3.8 | 0.7 | Usable Life Finished in 13.2 min. |
| | 30 | 2.4 | 6.1 | 1.2 | Usable Life Finished in 12.7 min. |
| (Usable life is finished due to chipping.) | | | | | |

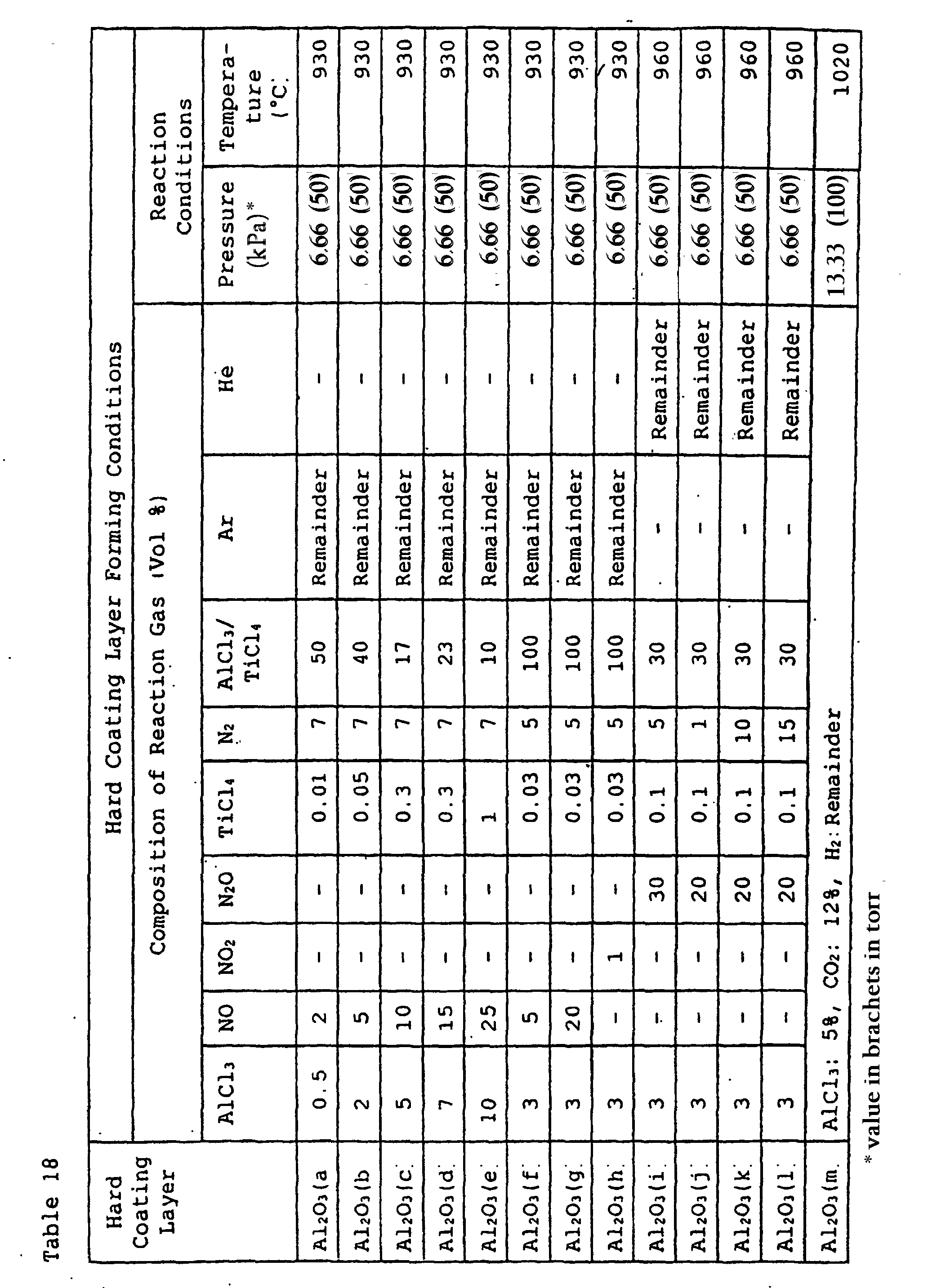

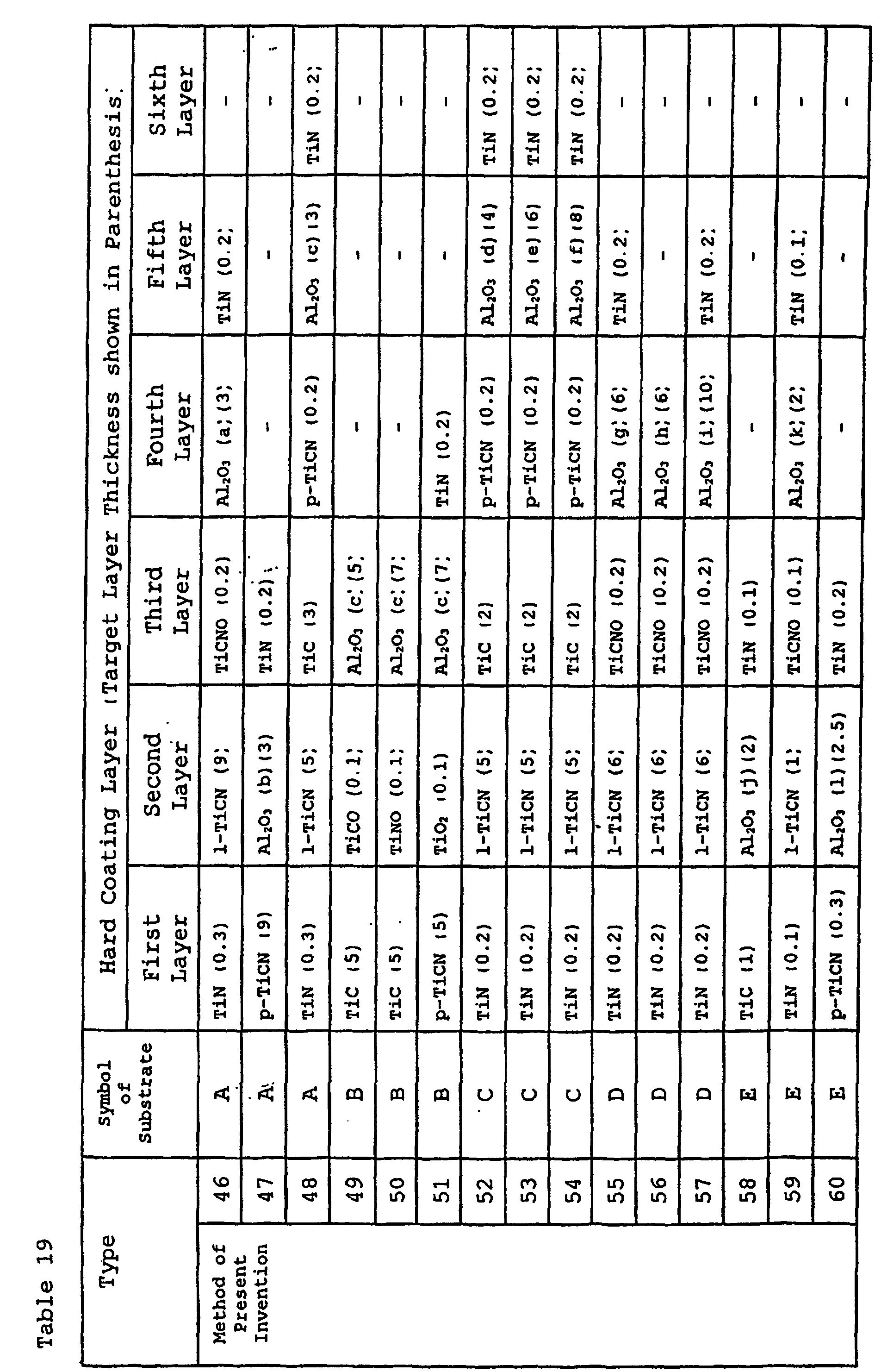

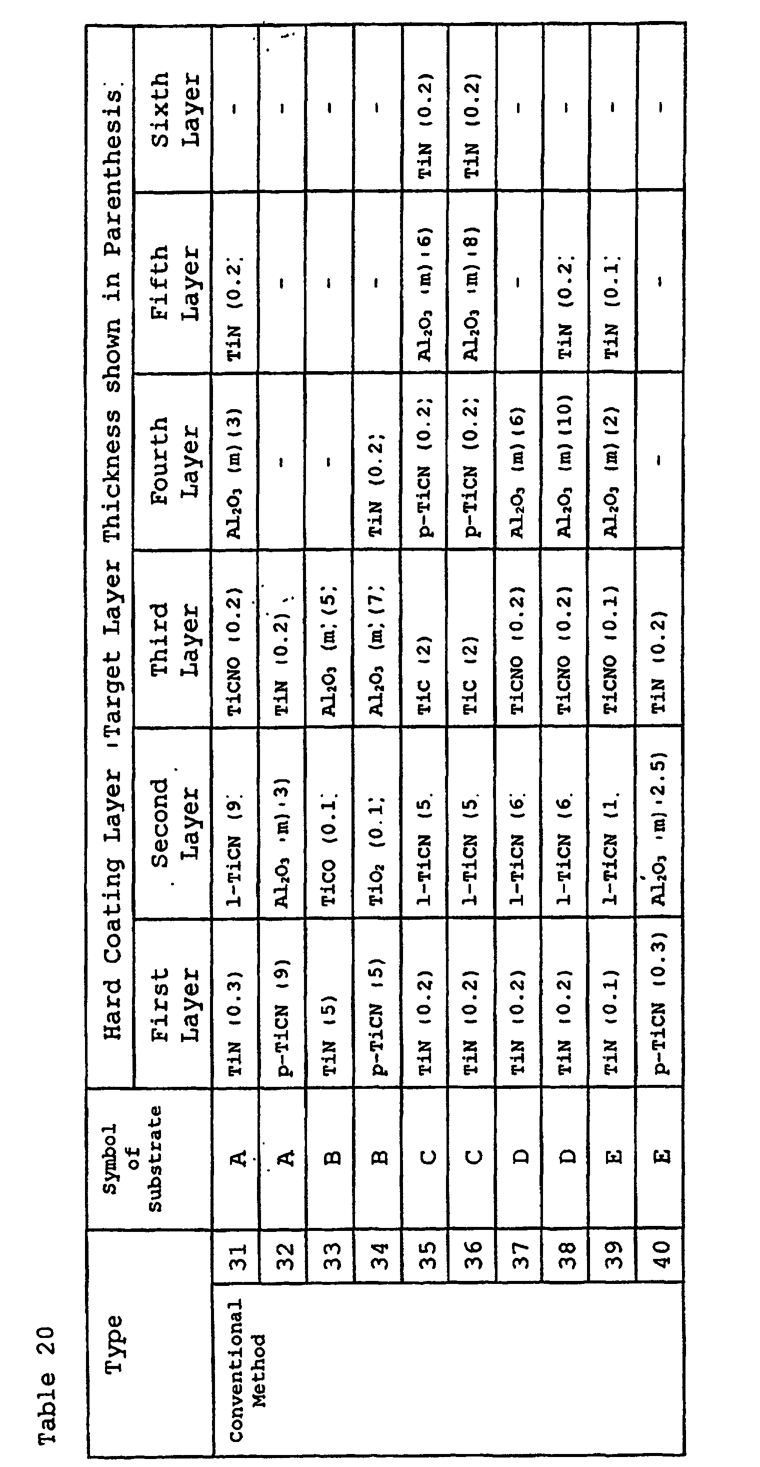

**Table 21**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Hard-Material-Coated Cemented Carbide Cutting Tool of Present Invention | 46 | 3.0 | 3.5 | 2.8 | 0.27 |
| | 47 | 3.0 | 3.4 | 2.9 | 0.20 |
| | 48 | 3.0 | 3.4 | 2.9 | 0.22 |
| | 49 | 5.1 | 5.7 | 4.8 | 0.29 |
| | 50 | 7.0 | 7.9 | 6.7 | 0.28 |
| | 51 | 7.1 | 7.9 | 6.9 | 0.25 |
| | 52 | 4.0 | 4.4 | 3.9 | 0.22 |
| | 53 | 5.9 | 7.0 | 5.6 | 0.19 |
| | 54 | 7.9 | 9.1 | 7.4 | 0.24 |
| | 55 | 6.0 | 6.8 | 5.8 | 0.30 |
| | 56 | 5.9 | 7.0 | 5.7 | 0.27 |
| | 57 | 10.1 | 11.4 | 9.9 | 0.27 |
| | 58 | 2.0 | 2.2 | 1.9 | 0.21 |
| | 59 | 2.0 | 2.2 | 2.0 | 0.24 |
| | 60 | 2.5 | 2.9 | 2.3 | 0.22 |

**Table 22**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Conventional Hard-Material-Coated Cement Carbide Cutting Tool | 31 | 3.0 | 4.7 | 1.3 | Usable Life Finished in 3.5 min. |
| | 32 | 2.9 | 5.0 | 1.6 | Usable Life Finished in 2.5 min. |
| | 33 | 5.0 | 9.1 | 2.6 | Usable Life Finished in 2.0 min. |
| | 34 | 6.9 | 12.0 | 3.8 | Usable Life Finished in 3.5 min. |
| | 35 | 6.0 | 11.1 | 2.9 | Usable Life Finished in 6.0 min. |
| | 36 | 7.8 | 13.7 | 3.7 | Usable Life Finished in 6.0 min. |
| | 37 | 5.9 | 10.4 | 2.7 | Usable Life Finished in 2.0 min. |
| | 38 | 9.6 | 16.6 | 5.0 | Usable Life Finished in 2.5 min. |
| | 39 | 2.0 | 3.3 | 1.2 | Usable Life Finished in 7.5 min. |
| | 40 | 2.5 | 4.2 | 1.2 | Usable Life Finished in 9.0 min. |
| (Usable life is finished due to chipping.) | | | | | |

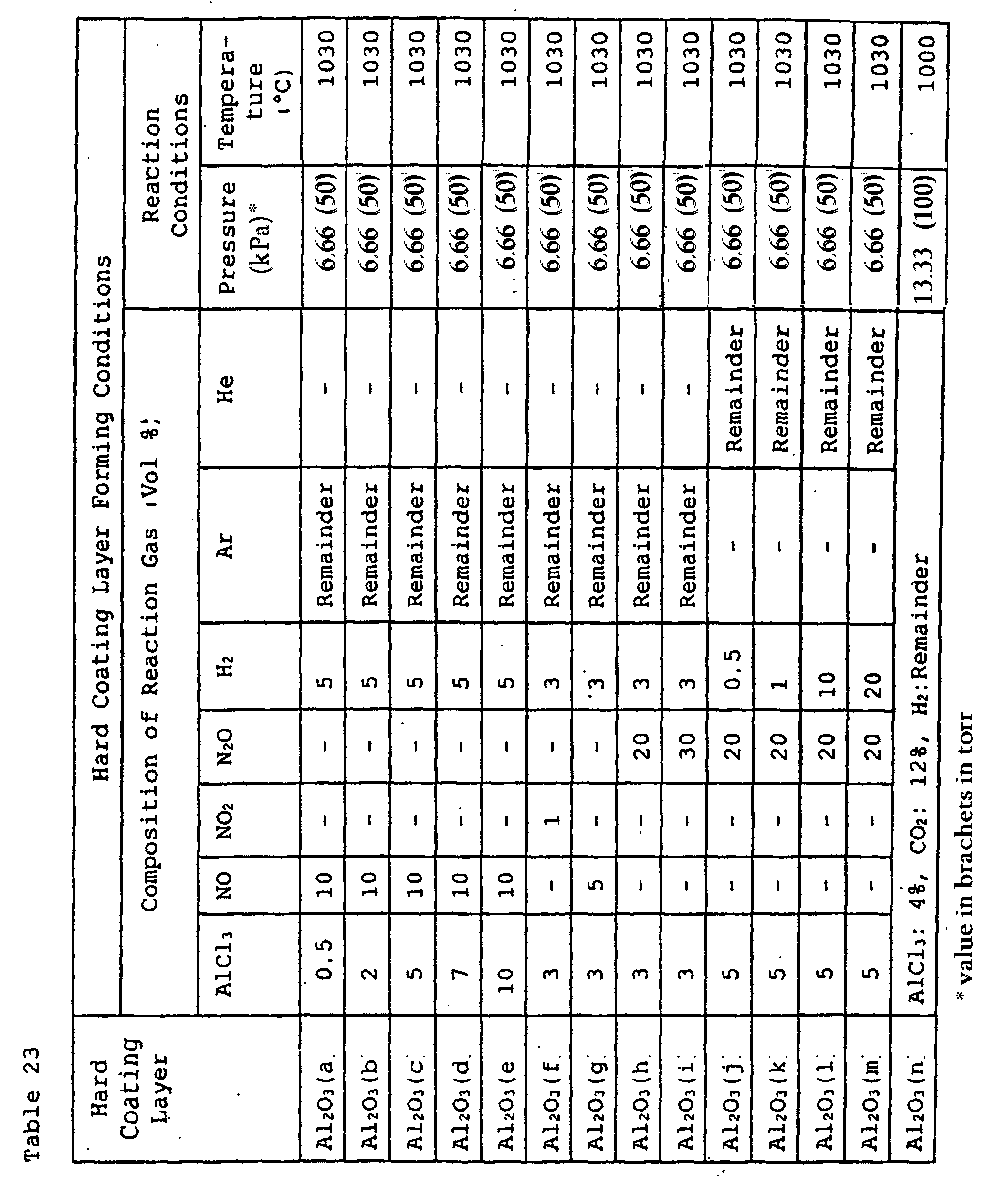

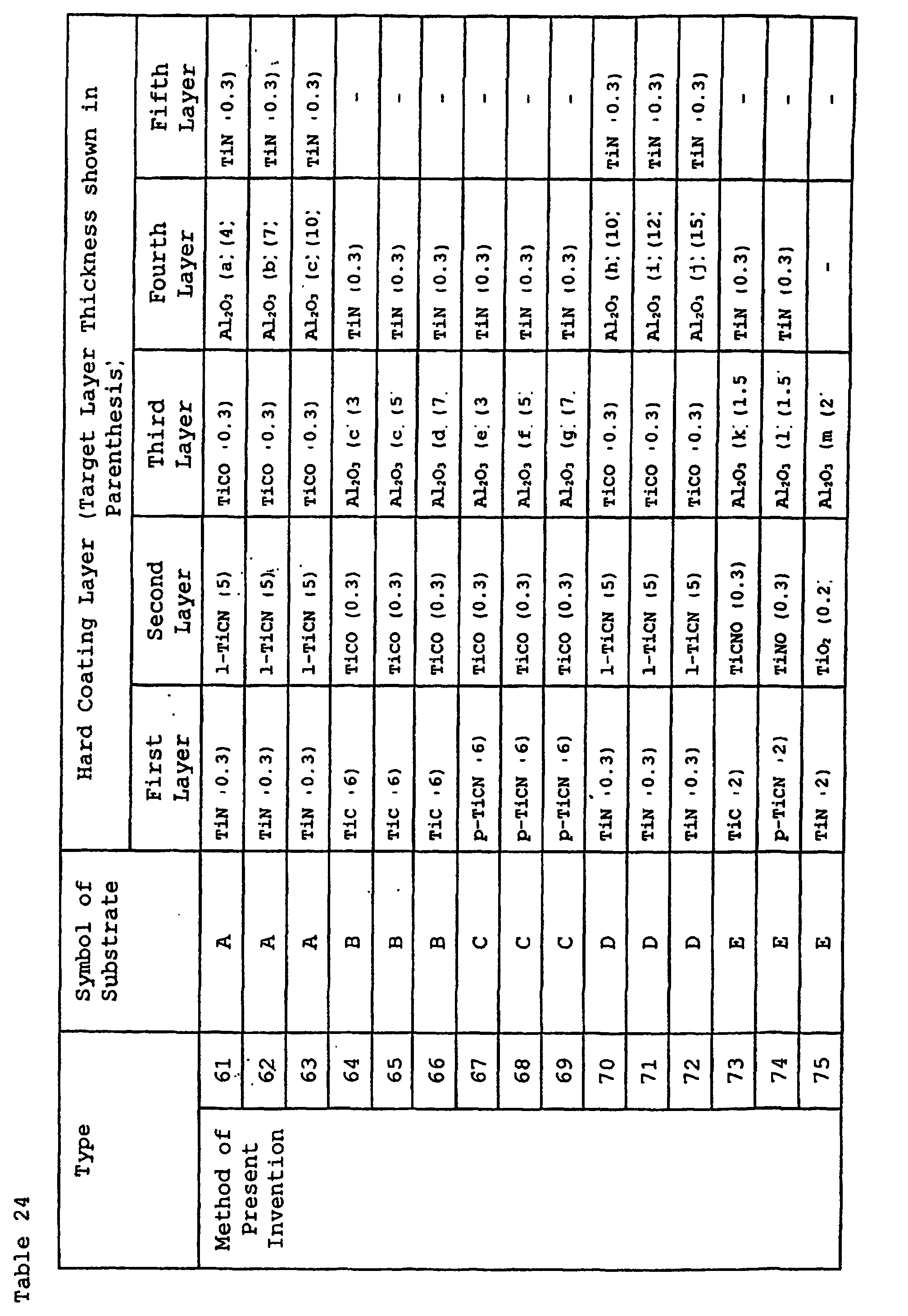

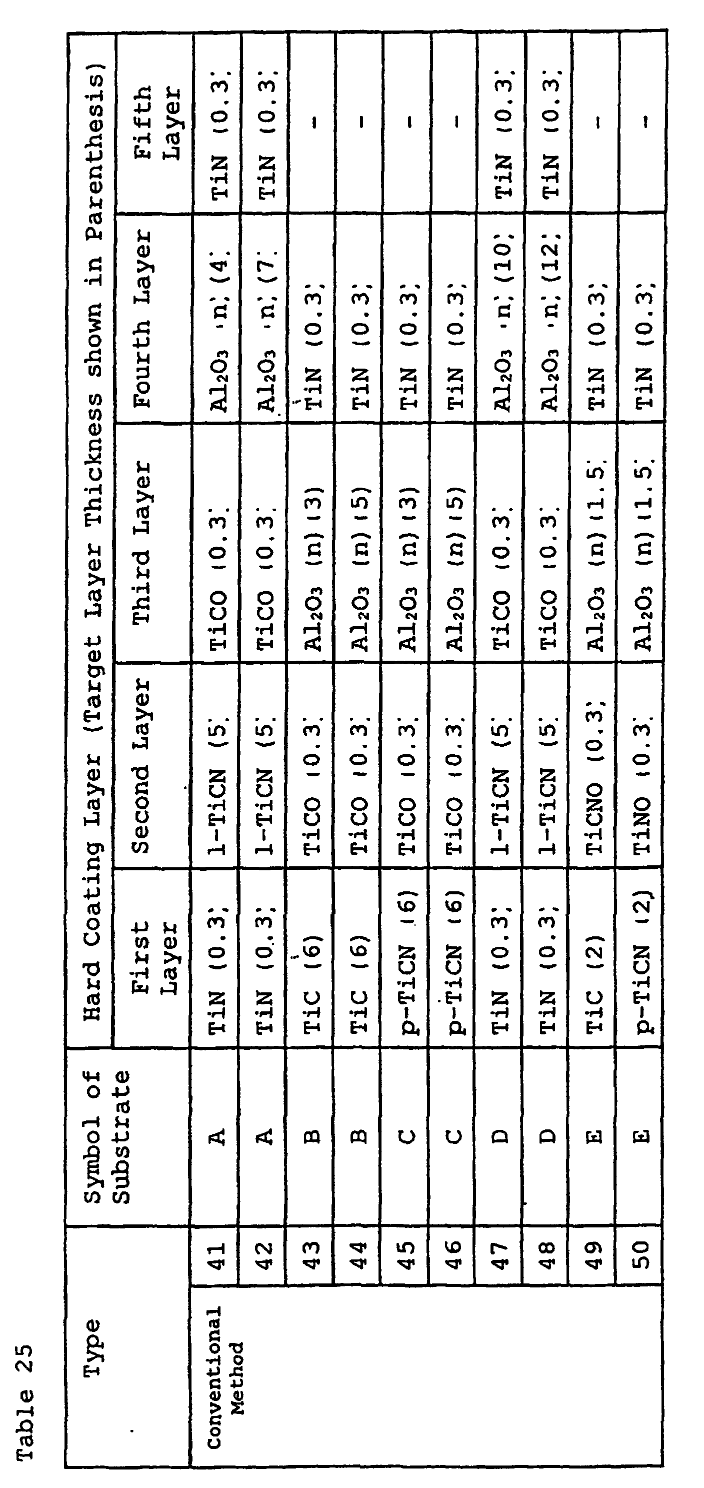

**Table 26**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Hard-Material-Coated Cemented Carbide Cutting Tool of Present Invention | 61 | 4.1 | 4.7 | 3.7 | 0.25 |
| | 62 | 7.2 | 8.0 | 6.5 | 0.25 |
| | 63 | 10.1 | 11.2 | 9.4 | 0.29 |
| | 64 | 3.0 | 3.4 | 2.8 | 0.28 |
| | 65 | 4.8 | 5.7 | 4.6 | 0.27 |
| | 66 | 6.9 | 8.2 | 6.5 | 0.32 |
| | 67 | 2.9 | 3.3 | 2.8 | 0.30 |
| | 68 | 5.0 | 5.7 | 4.4 | 0.31 |
| | 69 | 7.0 | 8.1 | 6.1 | 0.35 |
| | 70 | 10.2 | 11.4 | 9.0 | 0.22 |
| | 71 | 12.1 | 13.6 | 11.0 | 0.24 |
| | 72 | 14.6 | 17.0 | 13.2 | 0.25 |
| | 73 | 1.5 | 1.7 | 1.4 | 0.20 |
| | 74 | 1.4 | 1.7 | 1.4 | 0.22 |
| | 75 | 2.0 | 2.3 | 1.8 | 0.28 |

**Table 27**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Conventional Hard-Material-Coated Cement Carbide Cutting Tool | 41 | 4.2 | 7.6 | 2.0 | Usable Life Finished in 5.0 min. |
| | 42 | 6.8 | 11.0 | 3.1 | Usable Life Finished in 5.5 min. |
| | 43 | 2.9 | 5.2 | 1.4 | Usable Life Finished in 7.5 min. |
| | 44 | 5.0 | 8.9 | 2.2 | Usable Life Finished in 6.0 min. |
| | 45 | 2.9 | 4.7 | 1.6 | Usable Life Finished in 4.0 min. |
| | 46 | 4.9 | 8.1 | 2.7 | Usable Life Finished in 2.5 min. |
| | 47 | 9.7 | 17.1 | 4.0 | Usable Life Finished in 7.5 min. |
| | 48 | 11.6 | 19.7 | 4.5 | Usable Life Finished in 5.5 min. |
| | 49 | 1.5 | 2.4 | 0.8 | Usable Life Finished in 5.0 min. |
| | 50 | 1.5 | 2.6 | 0.8 | Usable Life Finished in 6.0 min. |
| (Usable life is finished due to chipping.) | | | | | |

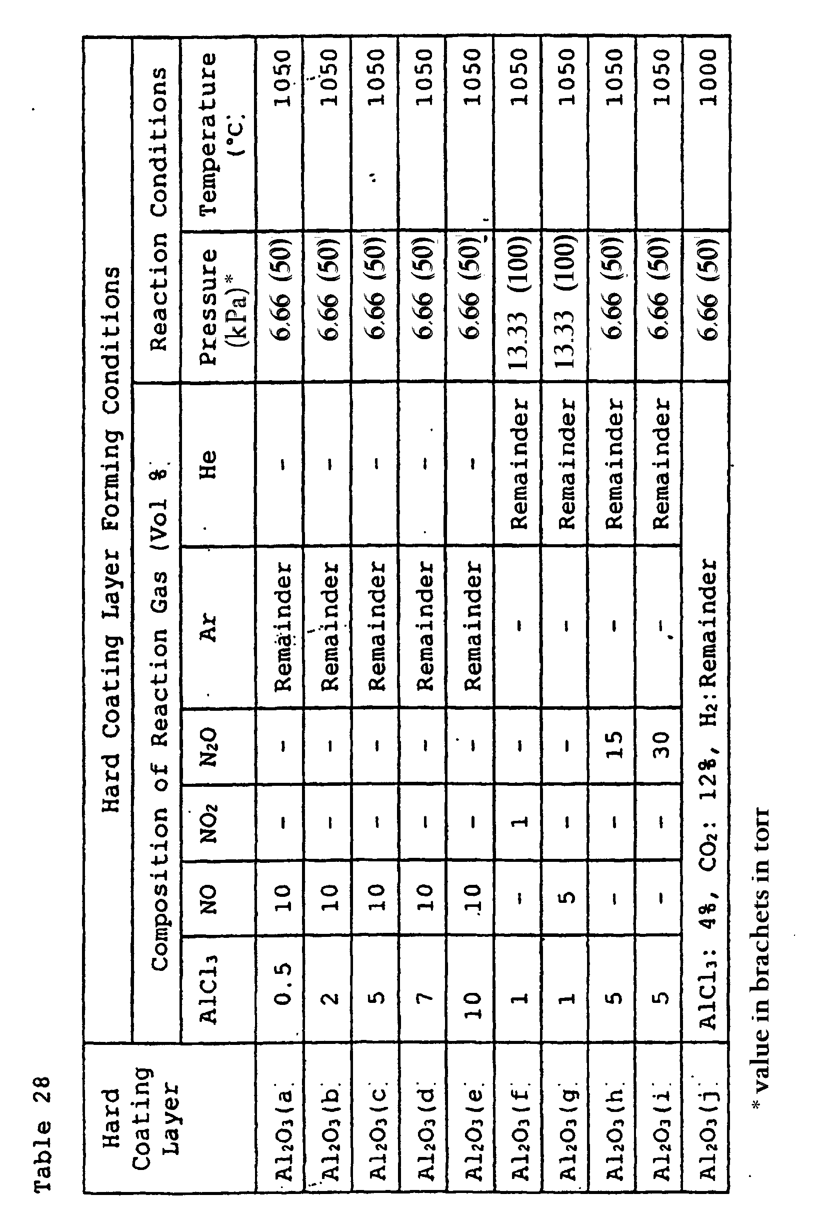

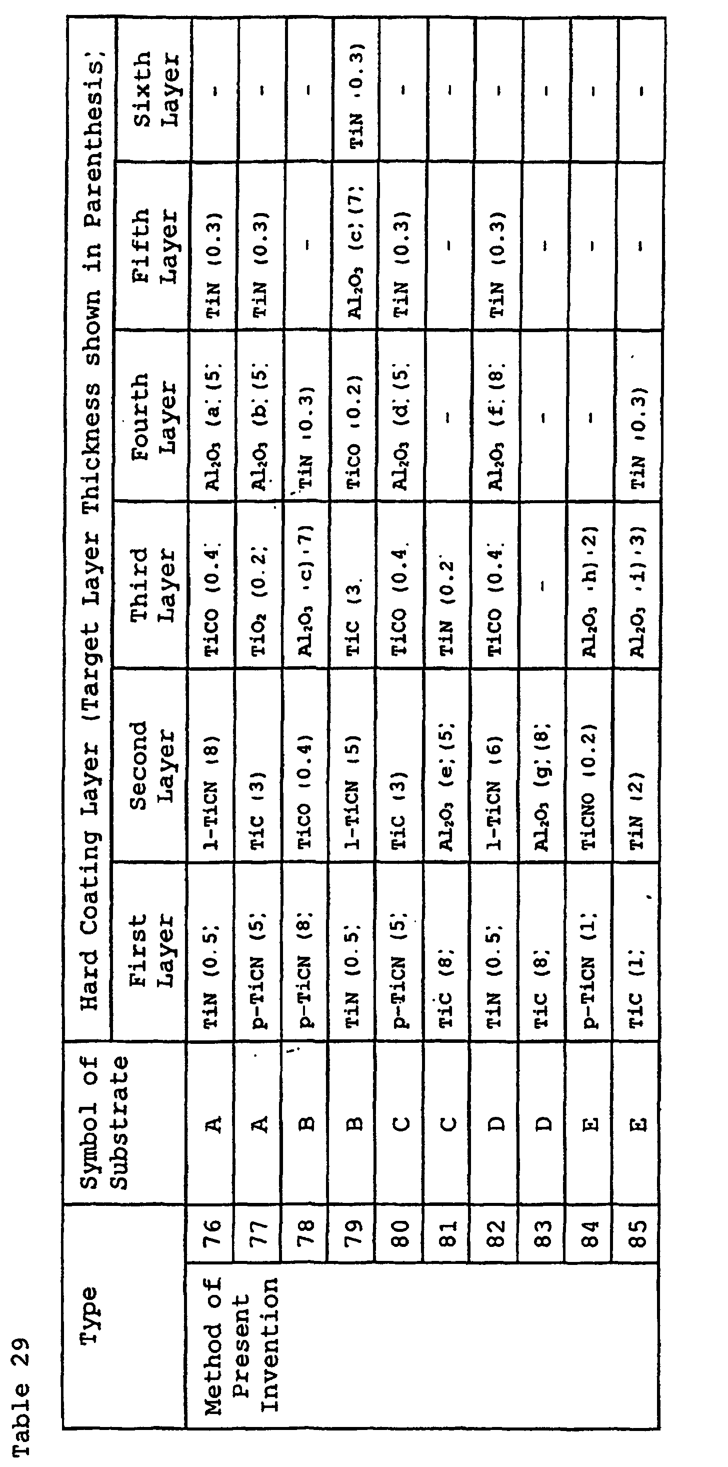

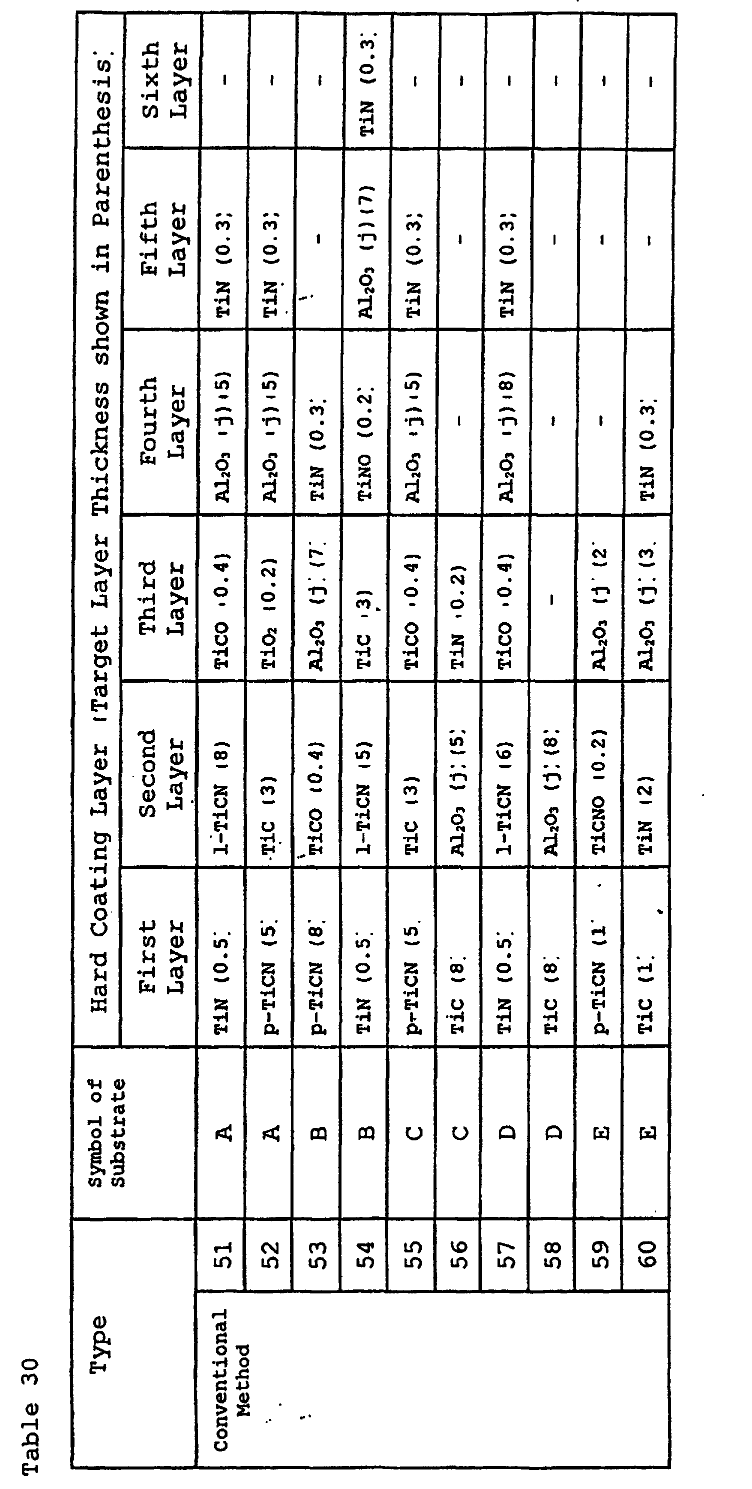

**Table 31**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Hard-Material-Coated Cemented Carbide Cutting Tool of Present Invention | 76 | 5.1 | 5.7 | 4.5 | 0.27 |
| | 77 | 5.0 | 5.5 | 4.5 | 0.31 |
| | 78 | 7.0 | 7.7 | 6.4 | 0.24 |
| | 79 | 6.8 | 7.5 | 6.3 | 0.25 |
| | 80 | 5.0 | 5.7 | 4.4 | 0.25 |
| | 81 | 5.1 | 5.9 | 4.7 | 0.29 |
| | 82 | 8.3 | 9.5 | 7.2 | 0.30 |
| | 83 | 8.0 | 9.7 | 7.2 | 0.33 |
| | 84 | 2.0 | 2.4 | 1.9 | 0.22 |
| | 85 | 3.0 | 3.4 | 2.6 | 0.23 |

**Table 32**

| Type | | Al₂O₃ Layer (Layer Thickness of Each Portion: µm) | | | Wear of Flank Face (mm) |
|---|---|---|---|---|---|
| | | Flank Face | Cutting Edge | Rake Face | |
| Conventional Hard-Material-Coated Cemented Carbide Cutting Tool | 51 | 4.9 | 8.7 | 2.4 | Usable Life Finished in 3.5 min. |
| | 52 | 4.9 | 9.5 | 2.0 | Usable Life Finished in 6.0 min. |
| | 53 | 7.0 | 15.1 | 3.1 | Usable Life Finished in 4.0 min. |
| | 54 | 7.0 | 13.7 | 2.4 | Usable Life Finished in 6.5 min. |
| | 55 | 5.0 | 8.1 | 2.1 | Usable Life Finished in 3.0 min. |
| | 56 | 4.9 | 9.4 | 2.4 | Usable Life Finished in 4.5 min. |
| | 57 | 7.9 | 17.1 | 3.4 | Usable Life Finished in 7.0 min. |
| | 58 | 8.1 | 16.6 | 4.1 | Usable Life Finished in 6.0 min. |
| | 59 | 2.1 | 3.4 | 1.2 | Usable Life Finished in 9.0 min. |
| | 60 | 3.1 | 5.1 | 1.4 | Usable Life Finished in 8.5 min. |
| (Usable life is finished due to chipping.) | | | | | |

## Claims

1. A method of manufacturing a coated cutting tool by coating the surface of a substrate with a hard coated layer using chemical vapor deposition and/or physical vapor deposition, comprising the step of using an inert gas type reaction gas in the formation of an aluminium oxide layer constituting said hard coated layer or a portion thereof, wherein the reaction gas comprises
| | |
|---|---|
| aluminum trichloride | 0.5 - 10 vol%, |
| nitrogen oxides | 1 - 30 vol%, |
| titanium tetrachloride | 0 - 1 vol%, |
| hydrogen | 0.5 - 20 vol%, |
| nitrogen | 1 - 15 vol%, |
| inert gas | remainder, |
and the ratio of aluminum trichloride and optional titanium tetrochloride being 5-100; and whereby
the reaction temperature is set to 850-1150°C.
the pressure is set to 2.66 - 26.6 kPa (20-200 torr) and
the thickness of the hard coated layer is set to 3 - 20 µm.

2. The method of manufacturing a coated cutting tool according to claim 1, wherein said reaction gas comprises titanium tetrachloride in an amount of 0.01 - 1 vol%.

3. The method of manufacturing a coated cutting tool according to any of claims 1 or 2, wherein the reaction gas comprises aluminum trichloride in an amount of 2 - 7 vol% and nitrogen oxides in an amount of 5 - 20 vol%.

4. A method of manufacturing a coated cutting tool according to one of claims 1 to 3, wherein said reaction gas comprises titanium tetrachloride in an amount of 0.1 - 0.5 vol%.

5. The method of manufacturing a coated cutting tool according to one of claims 1 to 4, wherein said reaction gas comprises hydrogen in an amount of 1 - 10 vol%.

6. The method of manufacturing a coated cutting tool according to one of claims 1 to 5. wherein the reaction using said reaction gas is carried out at a temperature of 900 - 1100°C.

7. The method of manufacturing a coated cutting tool according to claims 1 to 6, wherein the reaction using said reaction gas is carried out at a pressure of 5.3 - 13.3 kPa (40 - 100 torr).

8. The method of manufacturing a coated cutting tool according to one of claims 1 to 7, wherein the carrier gas in said reaction gas is an Ar gas.

9. The method of manufacturing a coated cutting tool according to one of claims 1 to 8, wherein the substrate is composed of tungsten carbide group cemented carbide.

10. A coated cutting tool excellent in chipping resistance, wherein the aluminum oxide layer of a hard coated layer is made by one of the manufacturing methods according to claims 1 to 9.

11. The coated cutting tool according to claim 10, wherein the aluminum oxide layer of the hard coated layer contains 0.005 15 wt% of components other than aluminum and oxygen.

12. The coated cutting tool according to claim 10 or 11, wherein the aluminum oxide layer in the hard coated layer contains 0.005 - 0.5 wt% of chlorine.

13. The coated cutting tool according to any of claims 10 to 12, wherein the aluminum oxide layer In the hard coated layer contains 1.5-15 wt% of titanium.

## Patentansprüche

1. Verfahren zur Herstellung eines beschichteten Schneidwerkzeugs durch Beschichten der Oberfläche eines Substrats mit einer harten Beschichtung unter Verwendung von chemischer Dampfabscheidung und/oder physikalischer Dampfabscheidung, umfassend den Schritt der Verwendung eines Reaktionsgases vom Inertgas-Typ bei der Bildung einer Aluminiumoxidschicht, die diese harte Beschichtung oder einen Teil davon bildet, wobei das Reaktionsgas umfasst
| | |
|---|---|
| Aluminiumtrichlorid | 0,5 - 10 Vol.-% |
| Stickstoffoxide | 1 - 30 Vol.-% |
| Titantetrachlorid | 0 - 1 Vol.-% |
| Wasserstoff | 0,5 - 20 Vol.-% |
| Stickstoff | 1 - 1 5 Vol.-% |
| Inertgas | Rest |
und das Verhältnis von Aluminiumtrichlorid und gegebenenfalls Titantetrachlorid 5 bis 100 beträgt; und wobei
die Reaktionstemperatur auf 850 bis 1150°C eingestellt wird,
der Druck auf 2,66 bis 26,6 kPa (20 bis 200 Torr) eingestellt wird, und
die Dicke der harten Beschichtung auf 3 bis 20 µm eingestellt wird.

2. Verfahren zur Herstellung eines beschichteten Schneidwerkzeugs nach Anspruch 1, wobei das Reaktionsgas Titantetrachlorid in einer Menge von 0,01 bis 1 Vol.-% umfasst.

3. Verfahren zur Herstellung eines beschichteten Schneidwerkzeugs nach einem der Ansprüche 1 oder 2, wobei das Reaktionsgas Aluminiumtrichlorid in einer Menge von 2 bis 7 Vol.-% und Stickoxide in einer Menge von 5 bis 20 Vol.-% umfasst.

4. Verfahren zur Herstellung eines beschichteten Schneidwerkzeugs nach einem der Ansprüche 1 bis 3, wobei das Reaktionsgas Titantetrachlorid in einer Menge von 0,1 bis 0,5 Vol,-% umfasst.

5. Verfahren zur Herstellung eines beschichteten Schneidwerkzeugs nach einem der Ansprüche 1 bis 4, wobei das Reaktionsgas Wasserstoff in einer Menge von 1 bis 10 Vol,-% umfasst.

6. Verfahren zur Herstellung eines beschichteten Schneidwerkzeugs nach einem der Ansprüche 1 bis 5, wobei die Reaktion unter Verwendung des Reaktionsgases bei einer Temperatur von 900 bis 1100°C durchgeführt wird.

7. Verfahren zur Herstellung eines beschichteten Schneidwerkzeugs nach den Ansprüchen 1 bis 6, wobei die Reaktion unter Verwendung des Reaktionsgases bei einem Druck von 5,3 bis 13,3 kPa (40 bis 100 Torr) durchgeführt wird.

8. Verfahren zur Herstellung eines beschichteten Schneidwerkzeugs nach einem der Ansprüche 1 bis 7, wobei das Trägergas im Reaktionsgas ein Ar-Gas ist.

9. Verfahren zur Herstellung eines beschichteten Schneidwerkzeugs nach einem der Ansprüche 1 bis 8, wobei das Substrat aus Sinterhartmetall der Wolframcarbid-Gruppe besteht.

10. Beschichtetes Schneidwerkzeug mit hervorragender Kantenfestigkeit, wobei die Aluminiumoxidschicht der harten Beschichtung nach einer der Herstellungsmethoden nach den Ansprüchen 1 bis 9 hergestellt ist.

11. Beschichtetes Schneidwerkzeug nach Anspruch 10, wobei die Aluminiumoxidschicht der harten Beschichtung 0,005 bis 15 Gew.-% an von Aluminium und Sauerstoff verschiedenen Komponenten enthält.

12. Beschichtetes Schneidwerkzeug nach Anspruch 10 oder 11, wobei die Aluminiumoxidschicht in der harten Beschichtung 0,005 bis 0,5 Gew.-% Chlor enthält.

13. Beschichtetes Schneidwerkzeug nach einem der Ansprüche 10 bis 12, wobei die Aluminiumoxidschicht in der harten Beschichtung 1,5 bis 15 Gew.-% Titan enthält.

## Revendications

1. Procédé de fabrication d'un outil de découpage enrobé par revêtement de la surface d'un substrat avec une couche de revêtement dur par un dépôt chimique en phase gazeuse et/ou un dépôt physique en phase gazeuse, comprenant une étape consistant à utiliser un gaz de réaction de type gaz inerte dans la formation d'une couche d'oxyde d'aluminium constituant ladite couche de revêtement dur ou une partie de celle-ci, dans lequel le gaz de réaction comprend
| | |
|---|---|
| du trichlorure d'aluminium | 0,5 à 10 % vol. |
| des oxydes d'azote | 1 à 30 % vol. |
| de tétrachlorure de titane | 0 à 1 % vol. |
| de l'hydrogène | 0,5 à 20 % vol. |
| de l'azote | 1 à 15 % vol. |
| un gaz inerte | pour le complément, |
avec un ratio du trichlorure d'aluminium au tétrachlorure de titane facultatif allant de 5 à 100 ; et où :
la température de réaction est ajustée entre 850 à 1150°C,
la pression est ajustée entre 2,66 et 26,6 kPa (20 à 200 torr) et
l'épaisseur de la couche de revêtement dur est ajustée entre 3 et 20 µm.

2. Procédé de fabrication d'un outil de découpage enrobé selon la revendication 1, dans lequel ledit gaz de réaction comprend du tétrachlorure de titane à une teneur de 0,01 à 1 % vol.

3. Procédé de fabrication d'un outil de découpage enrobé selon l'une quelconque des revendications 1 ou 2, dans lequel le gaz de réaction comprend du tétrachlorure de titane à une teneur de 2 à 7 % vol. et des oxydes d'azote à une teneur de 5 à 20 % vol.

4. Procédé de fabrication d'un outil de découpage enrobé selon une des revendications 1 à 3, dans lequel ledit gaz de réaction comprend du tétrachlorure de titane à une teneur de 0,1 à 0,5 % vol.

5. Procédé de fabrication d'un outil de découpage enrobé selon une des revendications 1 à 4, dans lequel ledit gaz de réaction comprend de l'hydrogène à une teneur de 1 à 10 % vol.

6. Procédé de fabrication d'un outil de découpage enrobé selon une des revendications 1 à 5, dans lequel la réaction utilisant ledit gaz de réaction est conduite à une température de 900 à 1100°C.

7. Procédé de fabrication d'un outil de découpage enrobé selon une des revendications 1 à 6, dans lequel la réaction utilisant ledit gaz de réaction est conduite à une pression de 5,3 à 13,3 kPa (40 à 100 torr).

8. Procédé de fabrication d'un outil de découpage enrobé selon une des revendications 1 à 7, dans lequel le gaz vecteur dans ledit gaz de réaction est un gaz Ar.

9. Procédé de fabrication d'un outil de découpage enrobé selon une des revendications 1 à 8, dans lequel le substrat est composé de carbure fritté du groupe du carbure de tungstène.

10. Outil de découpage enrobé excellent en terme de résistance à l'usure, dans lequel la couche d'oxyde d'aluminium d'une couche de revêtement dur est réalisée selon un des procédés de fabrication selon les revendications 1 à 9.

11. Outil de découpage enrobé selon la revendication 10, dans lequel la couche d'oxyde d'aluminium de la couche de revêtement dur contient de 0,005 à 15 % en poids de composants autre que l'aluminium et l'oxygène.

12. Outil de découpage enrobé selon la revendication 10 ou 11, dans lequel la couche d'oxyde d'aluminium de la couche de revêtement dur contient de0,005 à 15 % en poids de chlore.

13. Outil de découpage enrobé selon l'une quelconque des revendications 10 à 12, dans lequel la couche d'oxyde d'aluminium de la couche de revêtement dur contient de 1,5 à 15 % en poids de titane.
